# EUROPEAN PATENT APPLICATION

(11) **EP 4 753 402 A1**
(43) Date of publication of application: **03.06.2026**
(21) Application number: 25186361.9
(22) Date of filing: 30.06.2025
(51) Int. Cl.: H10D 64/64, H10D 30/47, H10D 62/17, H10D 30/01, H10D 62/85, H10D 64/00, H10D 64/23

(54) **SEMICONDUCTOR DEVICE**

(30) Priority: 28.11.2024 KR 20240174070
(71) Applicant: Samsung Electronics Co., Ltd., Suwon-si, Gyeonggi-do 16677 (KR)
(72) Inventor: PARK, Junhyuk, Suwon-si (KR); KANG, Ju Hui, Suwon-si (KR); KIM, Sanghyun, Suwon-si (KR); KIM, Jongseob, Suwon-si (KR); KIM, Joonyong, Suwon-si (KR); SON, Chaeyeon, Suwon-si (KR); AHN, Shihyun, Suwon-si (KR); JO, Junbeom, Suwon-si (KR); HWANGBO, Sumin, Suwon-si (KR)
(74) Representative: Marks & Clerk LLP

(57) **Abstract**

A semiconductor device includes a channel layer, a barrier layer located on the channel layer and including a material having an energy bandgap different from that of the channel layer, a gate electrode layer located on the barrier layer, a gate semiconductor layer between the barrier layer and the gate electrode layer, and source/ drain electrodes connected to the channel layer and located apart from the gate electrode layer. The gate electrode layer includes a metal nitride, has a lower layer on the gate semiconductor layer, an intermediate layer on the lower layer, and an upper layer on the intermediate layer. In the gate electrode layer, an atomic ratio (N/M) of nitrogen (N) to metal (M) of the metal nitride is greater in the intermediate layer than in the lower layer, and may be greater in the upper layer than in the intermediate layer.

## Description

### BACKGROUND

Power semiconductor devices become important as they are used in various fields including transportation fields such as electric vehicles, railroads, and electric trams, renewable energy systems such as solar power generation and wind power generation, and mobile devices. Power semiconductor devices are semiconductor devices used to handle high voltage or high current and perform functions such as power conversion and control in large power systems or high-output electronic devices. Power semiconductor devices have the ability and durability to handle high power, so they can handle large amounts of current and withstand high voltage. For example, power semiconductor devices can handle voltages from hundreds of volts to thousands of volts and currents from tens of amperes to thousands of amperes. Power semiconductor devices can improve the efficiency of use of electrical energy by minimizing power loss. Additionally, power semiconductor devices can be stably driven even in environments such as high temperature environments.

### SUMMARY

One aspect of the present disclosure provides a semiconductor device in which a lower surface of a gate electrode layer effectively forms a Schottky contact or an ohmic contact with a gate semiconductor layer so that a trade-off between leakage current and hysteresis may be optimized, and/or an upper surface of the gate electrode layer has low resistance characteristics so that a switching speed can be improved.

A semiconductor device according to one aspect includes a channel layer, a barrier layer located on the channel layer and including a material having an energy bandgap different from that of the channel layer, a gate electrode layer located on the barrier layer and extending in a first direction, a gate semiconductor layer between the barrier layer and the gate electrode layer, and a source electrode and a drain electrode connected to the channel layer and located apart from the gate electrode layer in a second direction different from the first direction, wherein the gate electrode layer includes a metal nitride, the gate electrode layer has a lower layer on the gate semiconductor layer, an intermediate layer on the lower layer, and an upper layer on the intermediate layer in a third direction different from the first direction and the second direction, and in the gate electrode layer, an atomic ratio (N/M) of nitrogen (N) to metal (M) of the metal nitride may be greater in the intermediate layer than in the lower layer, and may be greater in the upper layer than in the intermediate layer.

A semiconductor device according to another aspect includes a channel layer, a barrier layer located on the channel layer and including a material having an energy bandgap different from that of the channel layer, a gate electrode layer located on the barrier layer and extending in a first direction, a gate semiconductor layer between the barrier layer and the gate electrode layer, and a source electrode and a drain electrode connected to the channel layer and located apart from the gate electrode layer in a second direction different from the first direction, the gate electrode layer has a lower layer on the gate semiconductor layer, an intermediate layer on the lower layer, and an upper layer on the intermediate layer in a third direction different from the first direction and the second direction, and a work function of the gate electrode layer may be smaller in the intermediate layer than in the lower layer, and may be smaller in the upper layer than in the intermediate layer.

A semiconductor device according to another aspect includes a channel layer, a barrier layer located on the channel layer and including a material having an energy bandgap different from that of the channel layer, a gate electrode layer located on the barrier layer and extending in a first direction, a gate semiconductor layer between the barrier layer and the gate electrode layer, and a source electrode and a drain electrode connected to the channel layer and located apart from the gate electrode layer in a second direction different from the first direction, wherein the gate electrode layer includes a metal nitride, the gate electrode layer has a lower layer on the gate semiconductor layer, an intermediate layer on the lower layer, and an upper layer on the intermediate layer in a third direction different from the first direction and the second direction, in the gate electrode layer, an atomic ratio (N/M) of nitrogen (N) to metal (M) of the metal nitride may be greater in the upper layer than in the lower layer, and a dimension of an upper surface of the gate electrode layer in the second direction may be shorter than a dimension of a lower surface of the gate electrode layer in the second direction.

In a semiconductor device according to the implementations, a lower surface of a gate electrode layer effectively forms a Schottky contact or an ohmic contact with a gate semiconductor layer, so that a trade-off between leakage current and hysteresis can be optimized, and/or an upper surface of the gate electrode layer has low resistance characteristics, so that a switching speed can be improved.

At least some of the above and other features of the invention are set out in the claims.

### BRIEF DESCRIPTION OF THE DRAWINGS

FIG. 1 is a plan view showing a semiconductor device according to some implementations.
FIG. 2 is a cross-sectional view taken along line A-A' of FIG. 1.
FIG. 3 is an enlarged cross-sectional view of portion P of FIG. 2.
FIG. 4 is a graph showing the atomic ratio (N/M) of nitrogen (N) to metal (M) of a metal nitride along the third direction of a gate electrode layer of the semiconductor device of FIG. 1.
FIGS. 5 to 10 are average line graphs showing alternative atomic ratios (N/M) of nitrogen (N) to metal (M) of metal nitride along the third direction of the gate electrode layer.
FIG. 11 is an enlarged cross-sectional view of portion P of FIG. 2, according to an alternative implementation.
FIG. 12 is an enlarged cross-sectional view of portion P of FIG. 2, according to an alternative implementation.
FIG. 13 is an enlarged cross-sectional view of portion P of FIG. 2, according to an alternative implementation.
FIGS. 14 to 20 are cross-sectional views showing a method for manufacturing a semiconductor device according to some implementations in the order of processes.

### DETAILED DESCRIPTION

Hereinafter, various implementations of the present disclosure will be described in detail with reference to the attached drawings so that a person having ordinary skill in the art to which the present disclosure pertains can easily implement the present disclosure. The present disclosure may be embodied in many different forms and is not limited to the implementations set forth herein.

The drawings and description are to be regarded as illustrative in nature and not restrictive. Like reference numerals designate like elements throughout the specification.

The size and thickness of each constituent element as shown in the drawings are randomly indicated for better understanding and ease of description, and this disclosure is not necessarily limited to as shown. In the drawings, the thickness of layers, regions, etc., are exaggerated for clarity. In addition, in the drawings, for better understanding and ease of description, the thickness of some layers and areas is exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being disposed on or below the object portion and does not necessarily mean being disposed on the upper side of the object portion based on a gravitational direction.

In addition, unless explicitly described to the contrary, the word "comprise," and variations such as "comprises" or "comprising," will be understood to imply the inclusion of stated elements but not the exclusion of any other elements.

In addition, in this specification, the phrase "on a plane" means viewing a target portion from the top, and the phrase "on a cross-section" means viewing a cross-section formed by vertically cutting a target portion from the side.

In addition, throughout the specification, two directions which are parallel to the upper surface of the substrate and which intersect one another (e.g. which are different from one another) are defined as the first direction D1 and the second direction D2, respectively, and the direction perpendicular to the upper surface of the substrate is described as the third direction D3. For example, the first direction D1 and the second direction D2 may be perpendicular to each other.

These power semiconductor devices can be classified according to materials, and examples include SiC power semiconductor devices and GaN power semiconductor devices. Power semiconductor devices are manufactured using SiC or GaN instead of existing silicon (Si), and thereby the disadvantage of silicon, which has unstable characteristics at high temperatures, can be compensated. The SiC power semiconductor devices are resistant to high temperatures and have low power loss, and can be suitable for electric vehicles, renewable energy systems, etc. The GaN power semiconductor devices require high costs but are efficient in terms of speed and can be suitable for high-speed charging of mobile devices.

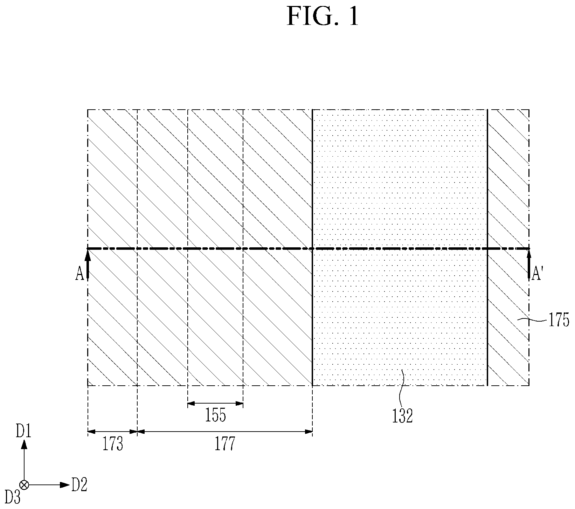

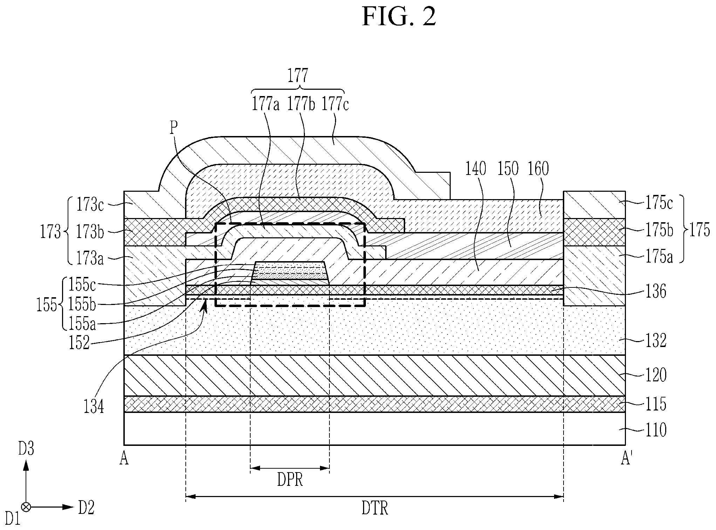

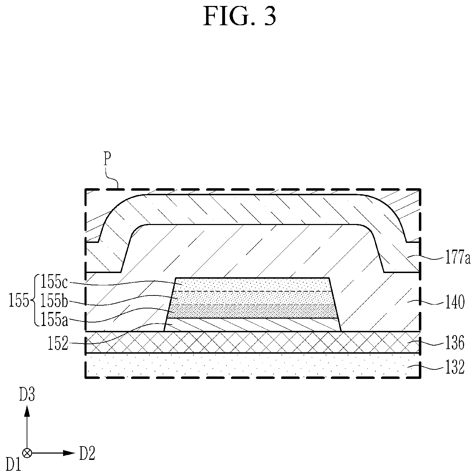

FIG. 1 is a plan view showing a semiconductor device according to some implementations. FIG. 2 is a cross-sectional view taken along line A-A' of FIG. 1. FIG. 3 is an enlarged cross-sectional view of portion P of FIG. 2.

For clear understanding and simple illustration, FIG. 1 mainly depicts a channel layer 132, a gate electrode layer 155, a source electrode 173, a field dispersion layer 177, and a drain electrode 175.

Referring to FIGS. 1 to 3, the semiconductor device includes a channel layer 132, a barrier layer 136 on the channel layer 132, a gate electrode layer 155 on the barrier layer 136, a gate semiconductor layer 152 positioned between the barrier layer 136 and the gate electrode layer 155, and a source electrode 173 and a drain electrode 175 located on both sides of the gate electrode layer 155 and connected to the channel layer 132.

The channel layer 132 is a layer that forms a channel between the source electrode 173 and the drain electrode 175, and a two-dimensional electron gas (2DEG) 134 may be located inside the channel layer 132. The two-dimensional electron gas 134 is a charge transport model used in solid-state physics and refers to a group of electrons that can move freely in two dimensions (e.g., in the D1-D2 plane direction) but cannot move in another dimension (e.g., in the D3 direction) and are tightly bound within the two dimensions. That is, the two-dimensional electron gas 134 can exist in a two-dimensional sheet-like form within a three-dimensional space. This two-dimensional electron gas 134 mainly appears in a semiconductor heterojunction structure, and in a semiconductor device according to some implementations, it can occur at the interface between the channel layer 132 and the barrier layer 136. For example, a two-dimensional electron gas 134 may be generated in the portion closest to the barrier layer 136 within the channel layer 132.

The channel layer 132 may include nitride including Group III-V materials, for example, Al, Ga, In, B, or a combination thereof. The channel layer 132 may be made of a single layer or multiple layers. As an example, the channel layer 132 may include AlₓIn_{y}Ga_{1-x-y}N (0≤x≤1, 0≤y≤1, x+y≤1). For example, the channel layer 132 may include AlN, GaN, InN, InGaN, AlGaN, AlInN, AlInGaN, or a combination thereof. The channel layer 132 may be a layer doped with impurities or a layer undoped with impurities. A thickness of the channel layer 132 may be about several hundred nm or less.

The channel layer 132 may be located on the substrate 110, and a seed layer 115, and/or a buffer layer 120 may be located between the substrate 110 and the channel layer 132. The substrate 110, the seed layer 115, and the buffer layer 120 can be layers necessary to form the channel layer 132 but may be omitted in some cases. For example, when a substrate made of GaN is used as the channel layer 132, at least one of the substrate 110, the seed layer 115, and the buffer layer 120 may be omitted. Considering that the price of a substrate made of GaN is relatively high, the channel layer 132 including GaN can be grown using the substrate 110 made of Si. In such implementations, as the lattice structure of Si and GaN are different, it may not be easy to grow the channel layer 132 directly on the substrate 110. Accordingly, the seed layer 115 and the buffer layer 120 can be first grown on the substrate 110, and then the channel layer 132 can be grown on the buffer layer 120. Additionally, at least one of the substrate 110, the seed layer 115, and the buffer layer 120 may be removed from the final structure of the semiconductor device after being used in the manufacturing process.

The substrate 110 may include a semiconductor material. For example, the substrate 110 may include sapphire, Si, SiC, AlN, GaN, diamond, glass, or a combination thereof. The substrate 110 may be a silicon on insulator (SOI) substrate. However, the material of the substrate 110 is not limited to this, and any other desirable substrates can be applied. In some cases, the substrate 110 may include an insulating material. For example, several layers, including the channel layer 132, may be first formed on a semiconductor substrate, then the semiconductor substrate may be removed and replaced with an insulating substrate.

The seed layer 115 may be located on the substrate 110. The seed layer 115 may be located directly on the substrate 110. However, it is not limited to this, and another predetermined layer may be further located between the substrate 110 and the seed layer 115. The seed layer 115 is a layer that serves as a seed for growing the buffer layer 120 and may be made of a crystal lattice structure that serves as a seed for the buffer layer 120. For example, the seed layer 115 may include AlN, but is not limited thereto.

The buffer layer 120 may be located on the seed layer 115. The buffer layer 120 may be located directly on the seed layer 115. However, it is not limited to this, and another predetermined layer may be further located between the seed layer 115 and the buffer layer 120. The buffer layer 120 may be located between the seed layer 115 and the channel layer 132. The buffer layer 120 may include nitride including Group III-V materials, for example, Al, Ga, In, B, or a combination thereof. The buffer layer 120 may include AlₓIn_{y}Ga_{1-x-y}N (0≤x≤1, 0≤y≤1, x+y≤1). For example, the buffer layer 120 may include AlN, GaN, InN, InGaN, AlGaN, AlInN, AlInGaN, or a combination thereof. The buffer layer 120 may be made of a single layer or multiple layers. For example, the buffer layer 120 may include a superlattice layer and a high-resistance layer.

The superlattice layer alleviates a difference in lattice constant and thermal expansion coefficient between the substrate 110 and the channel layer 132, thereby relieving tensile stress and compressive stress generated between the substrate 110 and the channel layer 132.

The high-resistance layer may be located on the superlattice layer. For example, the high-resistance layer may be located directly on the superlattice layer. However, the present disclosure is not limited to this, and other layers may be located between the superlattice layer and the high-resistance layer. The high-resistance layer may be located between the superlattice layer and the channel layer 132. The high-resistance layer can prevent the semiconductor device from deteriorating by preventing leakage current from flowing through the channel layer 132. The high-resistance layer may be made of a low-conductivity material to electrically insulate the substrate 110 and the channel layer 132.

For example, the high-resistance layer can have a resistivity value of greater than or equal to about 1.0X10⁶ Ω·cm. For example, the resistivity value of the high-resistance layer may be greater than or equal to about 1.0X10¹⁰ Ω·cm. As another example, the resistivity value of the high-resistance layer can be greater than or equal to about 1.0X10¹² Ω·cm. Resistivity values can be measured by forming a measuring electrode within a high-resistance layer and allowing current to flow.

The high-resistance layer may include a nitride including Group III-V materials, such as Al, Ga, In, B, or a combination thereof. The high-resistance layer may include AlₓIn_{y}Ga_{1-x-y}N (0≤x≤1, 0≤y≤1, x+y≤1), and may include, for example, AlN, GaN, InN, InGaN, AlGaN, AlInN, AlInGaN, or a combination thereof. The high-resistance layer may be composed of a single layer or multiple layers.

The barrier layer 136 may be located on the channel layer 132. The barrier layer 136 may be located directly on the channel layer 132. However, it is not limited to this, and another predetermined layer may be further located between the channel layer 132 and the barrier layer 136. A region of the channel layer 132 that is overlapped with the barrier layer 136 may be a drift region DTR. The drift region DTR may be located between the source electrode 173 and the drain electrode 175. When a potential difference occurs between the source electrode 173 and the drain electrode 175, carriers may move in the drift region DTR. The semiconductor device may be turned on/off depending on whether a voltage is applied to the gate electrode layer 155 and the magnitude of the voltage applied to the gate electrode layer 155. When a voltage greater than the threshold voltage is applied to the gate electrode layer 155 and the semiconductor device is turned on, a channel may be created in a depletion region DPR. Accordingly, movement of the carrier may occur in the drift region DTR. If a voltage lower than the threshold voltage is applied to the gate electrode layer 155 or no voltage is applied, the channel path may be blocked in the depletion region DPR and carrier movement may not occur.

The barrier layer 136 may include nitride including Group III-V materials, for example, Al, Ga, In, B, or a combination thereof. The barrier layer 136 may include AlₓIn_{y}Ga_{1-x-y}N (0≤x≤1, 0≤y≤1, x+y≤1). For example, the barrier layer 136 may include AlN, GaN, InN, InGaN, AlGaN, AlInN, AlInGaN, or a combination thereof. The energy bandgap of the barrier layer 136 can be adjusted by a composition ratio of Al or In.

The barrier layer 136 may include a semiconductor material having different characteristics from the channel layer 132. The barrier layer 136 may be different from the channel layer 132 in at least one of polarization characteristics, energy bandgap, and lattice constant. For example, the barrier layer 136 may include a material having a different energy bandgap than the channel layer 132. The barrier layer 136 may have a higher energy bandgap than the channel layer 132 and may have a higher electrical polarization rate than the channel layer 132. The two-dimensional electron gas 134 may be induced in the channel layer 132, which has a relatively low electrical polarization rate, by the barrier layer 136. In this regard, the barrier layer 136 may also be called a channel supply layer or a two-dimensional electron gas supply layer. The two-dimensional electron gas 134 may be formed within the portion of the channel layer 132 under the interface between the channel layer 132 and the barrier layer 136. The two-dimensional electron gas 134 may have very high electron mobility.

The gate electrode layer 155 may be located on the barrier layer 136. The gate electrode layer 155 may be overlapped with a portion of the barrier layer 136 in the third direction D3. The gate electrode layer 155 may be overlapped with a portion of the drift region DTR of the channel layer 132 in the third direction D3. The gate electrode layer 155 may be located between the source electrode 173 and the drain electrode 175 in the second direction D2. The gate electrode layer 155 may be spaced apart from the source electrode 173 and the drain electrode 175 in the second direction D2. The gate electrode layer 155 may extend along the first direction D1 on a plane. In other words, the gate electrode layer 155 may have a bar shape extending along the first direction D1 on a plane.

The gate electrode layer 155 may include a conductive metal nitride. For example, the metal (M) of the metal nitride may include tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), ruthenium (Ru), iridium (Ir), osmium (Os), silver (Ag), gold (Au), zinc (Zn), vanadium (V), or a combination thereof. In addition, the gate electrode layer 155 may include a metal nitride including titanium nitride (TiN), titanium silicon nitride (TiSiN), tantalum nitride (TaN), tantalum silicon nitride (TaSiN), tantalum titanium nitride (TaTiN), titanium aluminum nitride (TiAlN), tantalum aluminum nitride (TaAIN), tungsten nitride (WN), titanium aluminum carbon nitride (TiAlC-N), or a combination thereof.

The gate electrode layer 155 may have a lower layer 155a on the gate semiconductor layer 152, an intermediate layer 155b on the lower layer 155a, and an upper layer 155c on the intermediate layer 155b in the third direction D3. In other words, the lower layer 155a of the gate electrode layer 155 may be located closest to the gate semiconductor layer 152 in the third direction D3, the upper layer 155c may be located farthest from the gate semiconductor layer 152 in the third direction D3, and the intermediate layer 155b may be located between the lower layer 155a and the upper layer 155c in the third direction D3.

Additionally, the lower layer 155a may include the lower surface of the gate electrode layer 155, and the upper layer 155c may include the upper surface of the gate electrode layer 155. Here, the lower surface and the upper surface of the gate electrode layer 155 may face away from each other in the third direction D3, and for example, the lower surface of the gate electrode layer 155 may be in contact with the gate semiconductor layer 152, and the upper surface of the gate electrode layer 155 may be in contact with a first protective layer 140 described later. Additionally, the lower layer 155a, the intermediate layer 155b, and the upper layer 155c may be sequentially laminated in the third direction D3. The lower layer 155a, the intermediate layer 155b, and the upper layer 155c may be overlapped in a third direction D3.

For example, a dimension of the gate electrode layer 155 in the third direction D3, i.e., a thickness of the gate electrode layer 155, may be greater than or equal to about 500 Å, for example greater than or equal to about 600 Å , greater than or equal to about 700 Å, greater than or equal to about 1000 Å, greater than or equal to about 1300 Å, greater than or equal to about 1500 Å, greater than or equal to about 1700 Å, greater than or equal to about 1800 Å, or greater than or equal to about 1900 Å, and less than or equal to about 2000 Å, for example less than or equal to about 1900 Å, less than or equal to about 1800 Å, less than or equal to about 1700 Å, less than or equal to about 1600 Å, less than or equal to about 1500 Å, less than or equal to about 1300 Å, less than or equal to about 1000 Å, less than or equal to about 700 Å, or less than or equal to about 500 Å, or may be about 500 Å to about 2000 Å.

A dimension of the lower layer 155a in the third direction D3, i.e., a thickness of the lower layer 155a, may be greater than or equal to about 10 Å, for example 20 Å, greater than or equal to about 30 Å, greater than or equal to about 40 Å, greater than or equal to about 50 Å, greater than or equal to about 100 Å, greater than or equal to about 200 Å, greater than or equal to about 300 Å, greater than or equal to about 400 Å, greater than or equal to about 500 Å, greater than or equal to about 600 Å, greater than or equal to about 650 Å, greater than or equal to about 660 Å, greater than or equal to about 670 Å, greater than or equal to about 680 Å, or greater than or equal to about 690 Å, and less than or equal to about 800 Å, for example less than or equal to about 790 Å, less than or equal to about 780 Å, less than or equal to about 770 Å, less than or equal to about 760 Å, less than or equal to about 750 Å, less than or equal to about 700 Å, less than or equal to about 600 Å, less than or equal to about 500 Å, less than or equal to about 400 Å, less than or equal to about 300 Å, less than or equal to about 200 Å, less than or equal to about 100 Å, less than or equal to about 50 Å, less than or equal to about 40 Å, less than or equal to about 30 Å, or less than or equal to about 20 Å, or may be about 10 Å to about 700 Å. In other words, the lower layer 155a may be a region having a thickness of about 10 Å to about 1000 Å extending from the lower surface of the gate electrode layer 155 toward the inside of the gate electrode layer 155 in the third direction D3.

A dimension of the upper layer 155c in the third direction D3, i.e., a thickness of the upper layer 155c, may be greater than or equal to about 10 Å, for example greater than or equal to about 20 Å, greater than or equal to about 30 Å, greater than or equal to about 40 Å, greater than or equal to about 50 Å, greater than or equal to about 100 Å, greater than or equal to about 200 Å, greater than or equal to about 300 Å, greater than or equal to about 400 Å, greater than or equal to about 500 Å, greater than or equal to about 600 Å, greater than or equal to about 650 Å, greater than or equal to about 660 Å, greater than or equal to about 670 Å, greater than or equal to about 680 Å, or greater than or equal to about 690 Å, and less than or equal to about 800 Å, for example less than or equal to about 790 Å, less than or equal to about 780 Å, less than or equal to about 770 Å, less than or equal to about 760 Å, less than or equal to about 750 Å, less than or equal to about 700 Å, less than or equal to about 600 Å, less than or equal to about 500 Å, less than or equal to about 400 Å, less than or equal to about 300 Å, less than or equal to about 200 Å, less than or equal to about 100 Å, less than or equal to about 50 Å, less than or equal to about 40 Å, less than or equal to about 30 Å, or less than or equal to about 20 Å, or may be about 10 Å to about 700 Å. In other words, the upper layer 155c may be a region having a thickness of about 10 Å to about 1000 Å extending from the upper surface of the gate electrode layer 155 toward the inside of the gate electrode layer 155 in the third direction D3.

A dimension of the intermediate layer 155b in the third direction D3, i.e., a thickness of the intermediate layer 155b, may be greater than or equal to about 10 Å, for example greater than or equal to about 20 Å, greater than or equal to about 30 Å, greater than or equal to about 40 Å, greater than or equal to about 50 Å, greater than or equal to about 100 Å, greater than or equal to about 200 Å, greater than or equal to about 300 Å, greater than or equal to about 400 Å, greater than or equal to about 500 Å, greater than or equal to about 600 Å, greater than or equal to about 650 Å, greater than or equal to about 660 Å, greater than or equal to about 670 Å, greater than or equal to about 680 Å, or greater than or equal to about 690 Å, and less than or equal to about 800 Å, for example less than or equal to about 790 Å, less than or equal to about 780 Å, less than or equal to about 770 Å, less than or equal to about 760 Å, less than or equal to about 750 Å, less than or equal to about 700 Å, less than or equal to about 600 Å, less than or equal to about 500 Å, less than or equal to about 400 Å, less than or equal to about 300 Å, less than or equal to about 200 Å, less than or equal to about 100 Å, less than or equal to about 50 Å, less than or equal to about 40 Å, less than or equal to about 30 Å, or less than or equal to about 20 Å, or may be about 10 Å to about 700 Å.

For example, the intermediate layer 155b may mean an internal region of the gate electrode layer 155 excluding the lower layer 155a and the upper layer 155c in the gate electrode layer 155. The gate electrode layer 155 may include one intermediate layer 155b between the lower layer 155a and the upper layer 155c, but the gate electrode layer 155 may also include a plurality of intermediate layers 155b. In other words, a plurality of intermediate layers 155b having a certain thickness may be stacked between the lower layer 155a and the upper layer 155c.

In this way, the lower layer 155a, the intermediate layer 155b, and the upper layer 155c of the gate electrode layer 155 are arbitrarily set as three regions in which the gate electrode layer 155 is stacked along the third direction D3, and the boundaries of the lower layer 155a, the intermediate layer 155b, and the upper layer 155c may not actually be distinguished, and the gate electrode layer 155 may be formed as a single layer by a single process. However, the lower layer 155a may include the lower surface of the gate electrode layer 155, the intermediate layer 155b may include a middle point between the lower surface and the upper surface in the third direction D3 of the gate electrode layer 155, and the upper layer 155c may include the upper surface of the gate electrode layer 155.

For example, the lower layer 155a, the intermediate layer 155b, and the upper layer 155c of the gate electrode layer 155 may divide the dimension of the gate electrode layer 155 into three portions in the third direction D3. For example, the thickness of each of the lower layer 155a, the intermediate layer 155b, and the upper layer 155c of the gate electrode layer 155 may be less than or equal to about 50 %, for example less than or equal to about 40 %, less than or equal to about 30 %, less than or equal to about 20 %, less than or equal to about 10 %, or less than or equal to about 5 %, and greater than or equal to about 1 %, greater than or equal to about 5 %, greater than or equal to about 10 %, greater than or equal to about 20 %, greater than or equal to about 30 %, or greater than or equal to about 40 %, or may be about 1 % to about 30 %, or about 1 % to about 10 % based on a total thickness of the gate electrode layer 155.

The gate semiconductor layer 152 is located between the barrier layer 136 and the gate electrode layer 155. That is, the gate semiconductor layer 152 may be located on the barrier layer 136, and the gate electrode layer 155 may be located on the gate semiconductor layer 152. The gate electrode layer 155 may be in Schottky contact with the gate semiconductor layer 152. However, it is not limited to this, and in some cases, the gate electrode layer 155 may be in ohmic contact with the gate semiconductor layer 152. The gate semiconductor layer 152 may be overlapped with the gate electrode layer 155 in the third direction D3. The upper surface of the gate semiconductor layer 152 may be entirely covered by the gate electrode layer 155.

The gate semiconductor layer 152 may be located between the source electrode 173 and the drain electrode 175 in the second direction D2. The gate semiconductor layer 152 may be spaced apart from the source electrode 173 and the drain electrode 175 in the second direction D2. The gate semiconductor layer 152 may be located closer to the source electrode 173 than the drain electrode 175. That is, a separation distance between the gate semiconductor layer 152 and the source electrode 173 may be smaller than a separation distance between the gate semiconductor layer 152 and the drain electrode 175.

The gate semiconductor layer 152 may include nitride including Group III-V materials, for example, Al, Ga, In, B, or a combination thereof. The gate semiconductor layer 152 may include AlₓIn_{y}Ga_{1-x-y}N (0≤x≤1, 0≤y≤1, x+y≤1). For example, the gate semiconductor layer 152 may include AlN, GaN, InN, InGaN, AlGaN, AlInN, AlInGaN, or a combination thereof. The gate semiconductor layer 152 may include a material having an energy bandgap different from that of the barrier layer 136. For example, the gate semiconductor layer 152 may include GaN, and the barrier layer 136 may include AlGaN. The gate semiconductor layer 152 may be doped with a predetermined impurity. The impurity doped into the gate semiconductor layer 152 may be a p-type dopant that can provide holes. For example, the gate semiconductor layer 152 may include GaN doped with p-type impurities. That is, the gate semiconductor layer 152 may be made of a p-GaN layer. However, it is not limited to this, and the gate semiconductor layer 152 may be a p-AlGaN layer. The impurity doped into the gate semiconductor layer 152 may be magnesium (Mg). The gate semiconductor layer 152 may be made of a single layer or multiple layers.

A depletion region DPR may be formed in the channel layer 132 by the gate semiconductor layer 152. The depletion region DPR may be located within the drift region DTR and may have a narrower width than the drift region DTR. As the gate semiconductor layer 152 having a different energy bandgap from the barrier layer 136 is located on the barrier layer 136, a level of the energy band of a portion of the barrier layer 136 that is overlapped with the gate semiconductor layer 152 may increase. Accordingly, the depletion region DPR may be formed in the area of the channel layer 132 that is overlapped with the gate semiconductor layer 152. The depletion region DPR may be a region in the channel path of the channel layer 132 where the two-dimensional electron gas 134 is not formed or may have a lower electron concentration than the remaining regions. That is, the depletion region DPR may refer to a region where the flow of the two-dimensional electron gas 134 is interrupted within the drift region DTR. As the depletion region DPR is generated, current does not flow between the source electrode 173 and the drain electrode 175, and the channel path may be blocked. Accordingly, the semiconductor device may have normally-off characteristics.

In other words, the semiconductor device may be a normally-off semiconductor device (HEMT, High Electron Mobility Transistor). In a normal state in which no voltage is applied to the gate electrode layer 155, a depletion region DPR exists and the semiconductor device may be in an off state. When a voltage higher than the threshold voltage is applied to the gate electrode layer 155, the depletion region DPR disappears, and the two-dimensional electron gas 134 may be connected without being disconnected within the drift region DTR. That is, the two-dimensional electron gas 134 may be formed throughout the channel path between the source electrode 173 and the drain electrode 175, and the semiconductor device may be in an on state. In summary, the semiconductor device may include semiconductor layers with different electrical polarization characteristics, and a semiconductor layer with a relatively high polarization rate can induce a two-dimensional electron gas 134 in another semiconductor layer that forms a heterojunction therewith. This two-dimensional electron gas 134 can be used as a channel between the source electrode 173 and the drain electrode 175, and the continuation or interruption of the flow of the two-dimensional electron gas 134 can be controlled by the bias voltage applied to the gate electrode layer 155. In the gate-off state, the flow of the two-dimensional electron gas 134 is blocked, and thus current may not flow between the source electrode 173 and the drain electrode 175. In the gate-on state, the two-dimensional electron gas 134 continues to flow, and thus current may flow between the source electrode 173 and the drain electrode 175.

Although the case where the semiconductor device is a normally-off high electron mobility transistor has been described above, the present disclosure is not limited thereto. For example, the semiconductor device may be a normally-on high electron mobility transistor. In the case of a normally-on high electron mobility transistor, the gate semiconductor layer 152 may be omitted, and accordingly, the gate electrode layer 155 may be located directly on the barrier layer 136. That is, the gate electrode layer 155 may contact the barrier layer 136. However, the present disclosure is not limited thereto, and a gate dielectric layer may be interposed between the gate electrode layer 155 and the barrier layer 136. In this structure, the two-dimensional electron gas 134 can be used as a channel while no voltage is applied to the gate electrode layer 155, and current may flow between the source electrode 173 and the drain electrode 175. Additionally, when a negative voltage is applied to the gate electrode layer 155, a depletion region DPR in which the flow of the two-dimensional electron gas 134 is cut off may be generated at the bottom of the gate electrode layer 155.

As described above, when the semiconductor device is a normally-off high electron mobility transistor, the gate electrode layer 155 may be located on the gate semiconductor layer 152. In order to improve the switching speed while optimizing the trade-off between leakage current and hysteresis of the normally-off semiconductor device, the gate electrode layer 155 needs to have low resistance characteristics while effectively forming a Schottky contact or ohmic contact with the gate semiconductor layer 152.

To this end, the gate electrode layer 155 may have a different atomic ratio (N/M) of nitrogen (N) to metal (M) of the metal nitride along the third direction D3. For example, the atomic ratio (N/M) of nitrogen (N) to metal (M) of the metal nitride on the lower surface of the gate electrode layer 155 may be smaller than the atomic ratio (N/M) of nitrogen (N) to metal (M) of the metal nitride on the upper surface of the gate electrode layer 155. In this case, the resistivity at the lower surface of the gate electrode layer 155 may be greater than the resistivity at the upper surface of the gate electrode layer 155, and the work function at the upper surface of the gate electrode layer 155 may be smaller than the work function at the lower surface of the gate electrode layer 155.

Accordingly, the lower surface of the gate electrode layer 155 may effectively form a Schottky contact or an ohmic contact with the gate semiconductor layer 152, thereby optimizing the trade-off between leakage current and hysteresis, and the upper surface of the gate electrode layer 155 can improve the switching speed of the semiconductor device by having low resistance characteristics.

For example, in the gate electrode layer 155, the atomic ratio (N/M) of nitrogen (N) to metal (M) of the metal nitride may be greater in the intermediate layer 155b than in the lower layer 155a and may be greater in the upper layer 155c than in the intermediate layer 155b.

For example, when the metal nitride includes titanium nitride (TiN), in the gate electrode layer 155, the atomic ratio of nitrogen (N) to titanium (Ti) of the titanium nitride (N/Ti) may be greater in the intermediate layer 155b than in the lower layer 155a and may be greater in the upper layer 155c than in the intermediate layer 155b.

Here, when the metal nitride includes a plurality of materials, such as titanium silicon nitride (TiSiN), tantalum silicon nitride (TaSiN), tantalum titanium nitride (TaTiN), titanium aluminum nitride (TiAlN), tantalum aluminum nitride (TaAIN), or titanium aluminum carbon nitride (TiAlC-N), in the atomic ratio (N/M) of nitrogen (N) to metal (M) of the metal nitride, the metal (M) may represent a sum of the contents of the plurality of metals. For example, the atomic ratio (N/M) of nitrogen (N) to metal (M) in titanium silicon nitride (TiSiN) may be an atomic ratio (N/(Ti+Si)) of nitrogen (N) to titanium and silicon (Ti+Si).

For example, in the lower layer 155a of the gate electrode layer 155, the atomic ratio (N/M) of nitrogen (N) to metal (M) may be greater than or equal to about 0.6, for example greater than or equal to about 0.7, greater than or equal to about 0.8, or greater than or equal to about 0.9, and less than about 1.0, for example less than or equal to about 0.9, less than or equal to about 0.8, or less than or equal to about 0.7, or may be about 0.6 to less than about 1.0, or about 0.8 to about 0.9.

In the upper layer 155c of the gate electrode layer 155, the atomic ratio (N/M) of nitrogen (N) to metal (M) may be greater than or equal to about 1.0, for example greater than or equal to about 1.1, greater than or equal to about 1.2, greater than or equal to about 1.3, or greater than or equal to about 1.4, and less than or equal to about 1.5, for example, less than or equal to about 1.4, less than or equal to about 1.3, less than or equal to about 1.2, or less than or equal to about 1.1, or may be about 1.0 to about 1.5, or about 1.0 to about 1.2.

In the intermediate layer 155b of the gate electrode layer 155, the atomic ratio (N/M) of nitrogen (N) to metal (M) may be greater than about 0.9, for example greater than or equal to about 1.0, or greater than or equal to about 1.1, and less than about 1.2, for example less than or equal to about 1.1, or less than or equal to about 1.0, or greater than about 0.9 to less than about 1.2.

Here, the atomic ratio (N/M) of nitrogen (N) to metal (M) of the metal nitride in the gate electrode layer 155 may be measured by analyzing cross-sectional images (e.g., FIGS. 2 and 3) obtained by cutting the gate electrode layer 155 in the second direction D2 and the third direction D3 perpendicular to the first direction D1 using a scanning electron microscope (SEM) or a scanning transmission electron microscope (STEM) using an electron beam microanalyzer (EPMA). When performing component analysis, etc. using an electron beam microanalyzer (EPMA), an energy dispersive spectrometer (EDS) or wavelength dispersive spectrometer (WDS) may be used as an X-ray spectrometer.

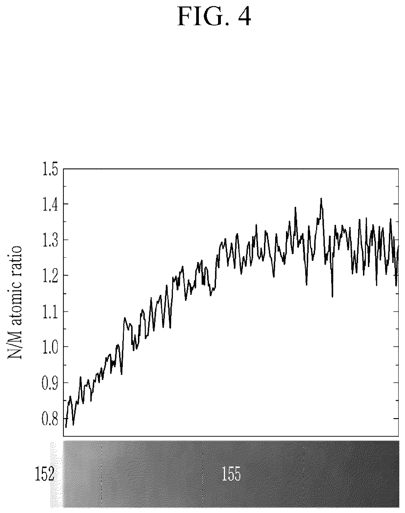

When the atomic ratio (N/M) of nitrogen (N) to metal (M) of the metal nitride along the third direction D3 of the gate electrode layer 155 is measured using the above-described method, a graph such as that in FIG. 4 may be, for example obtained. FIG. 4 is a graph showing the atomic ratio (N/M) of nitrogen (N) to metal (M) of a metal nitride along the third direction D3 of the gate electrode layer 155. In FIG. 4, the x-axis represents the position of the gate electrode layer 155 along the third direction D3, the left end represents a lower surface of the gate electrode layer 155 in contact with the gate semiconductor layer 152, and the right end represents an upper surface of the gate electrode layer 155.

Referring to FIG. 4, it can be seen that the atomic ratio of nitrogen (N) to metal (M) of the metal nitride (N/M) shows a repetitive pattern of increase and decrease in microscopic sections due to the chemical structure of the metal nitride, the element mapping interval, and the presence of other elements, but the average value thereof shows a pattern of substantially increasing from the lower surface to the upper surface along the third direction D3 of the gate electrode layer 155.

For example, when the atomic ratio (N/M) of nitrogen (N) to metal (M) of the metal nitride measured at points x₁, x₂, x₃,..., xₙ spaced at regular intervals along the third direction D3 of the gate electrode layer 155 is represented as f(x₁), f(x₂), f(x₃),..., f(xₙ), respectively, it can be defined that the atomic ratio (N/M) of nitrogen (N) to metal (M) of the metal nitride substantially increases when the correlation coefficient value between x₁, x₂, x₃,..., xₙ and f(x₁), f(x₂), f(x₃),..., f(xₙ) has a positive value. In addition, when all of the correlation coefficient values obtained for the case where n is 4 or greater are positive, it can be defined that the atomic ratio of nitrogen (N) to metal (M) of the metal nitride (N/M) substantially increases.

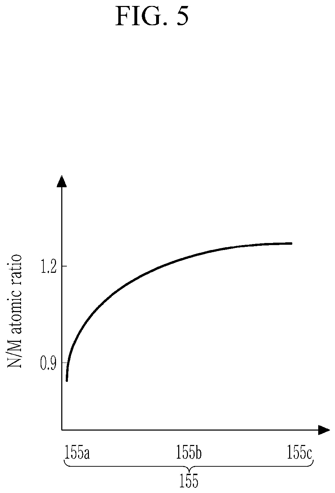

FIGS. 5 to 10 are average line graphs showing the atomic ratio (N/M) of nitrogen (N) to metal (M) of metal nitride along the third direction of the gate electrode layer 155. For example, the average line graph may be a graph that connects the arithmetic mean values of f(x₁), f(x₂), f(x₃),..., f(xₙ), where the atomic ratio (N/M) of nitrogen (N) to metal (M) of the metal nitride measured at points x₁, x₂, x₃,..., xₙ spaced at regular intervals along the third direction D3 of the gate electrode layer 155 is represented as f(x₁), f(x₂), f(x₃),..., f(xₙ). An interval of n for calculating the arithmetic mean value may be, for example, greater than or equal to about 4, greater than or equal to about 5, greater than or equal to about 6, greater than or equal to about 7, greater than or equal to about 8, greater than or equal to about 9, or greater than or equal to about 10.

Referring to FIGS. 5 to 10, in the gate electrode layer 155, the atomic ratio (N/M) of nitrogen (N) to metal (M) of the metal nitride may increase as it moves away from the gate semiconductor layer 152 in the third direction D3.

For example, in the gate electrode layer 155, the atomic ratio (N/M) of nitrogen (N) to metal (M) of the metal nitride may not only increase, but may also be continuous, when moving away from the gate semiconductor layer 152 in the third direction D3. In other words, at the interface between the lower layer 155a and the intermediate layer 155b of the gate electrode layer 155, the atomic ratio (N/M) in the lower layer 155a may be the same as the atomic ratio (N/M) in the intermediate layer 155b. Additionally, at the interface between the intermediate layer 155b and the upper layer 155c, the atomic ratio (N/M) in the intermediate layer 155b may be the same as the atomic ratio (N/M) in the upper layer 155c. For example, FIGS. 5 to 8 and FIG. 10 show that the atomic ratio (N/M) of nitrogen (N) to metal (M) of the metal nitride in the gate electrode layer 155 not only increases, but is also continuous, when moving away from the gate semiconductor layer 152 in the third direction D3.

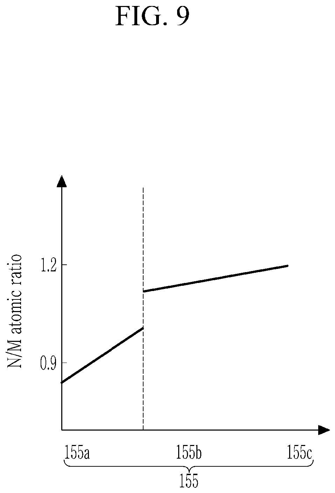

Alternatively, in the gate electrode layer 155, the atomic ratio (N/M) of nitrogen (N) to metal (M) of the metal nitride may increase stepwise as it moves away from the gate semiconductor layer 152 in the third direction D3. In other words, at the interface between the lower layer 155a and the intermediate layer 155b of the gate electrode layer 155, the atomic ratio (N/M) in the lower layer 155a may be smaller than the atomic ratio (N/M) in the intermediate layer 155b. Additionally, at the interface between the intermediate layer 155b and the upper layer 155c, the atomic ratio (N/M) in the intermediate layer 155b may be smaller than the atomic ratio (N/M) in the upper layer 155c. For example, FIG. 9 shows that the atomic ratio (N/M) of nitrogen (N) to metal (M) of the metal nitride in the gate electrode layer 155 increases stepwise as it moves away from the gate semiconductor layer 152 in the third direction D3, and that at the interface between the lower layer 155a and the intermediate layer 155b of the gate electrode layer 155, the atomic ratio (N/M) in the lower layer 155a is smaller than the atomic ratio (N/M) in the intermediate layer 155b.

For example, in the lower layer 155a of the gate electrode layer 155, the atomic ratio (N/M) of nitrogen (N) to metal (M) of the metal nitride may be constant, increase stepwise, or increase continuously when moving away from the gate semiconductor layer 152 in the third direction D3. In the intermediate layer 155b of the gate electrode layer 155, the atomic ratio (N/M) of nitrogen (N) to metal (M) of the metal nitride may be constant, increase stepwise, or increase continuously when moving away from the gate semiconductor layer 152 in the third direction D3. In the upper layer 155c of the gate electrode layer 155, the atomic ratio (N/M) of nitrogen (N) to metal (M) of the metal nitride may be constant, increase stepwise, or increase continuously when moving away from the gate semiconductor layer 152 in the third direction D3. However, in any one layer selected from the lower layer 155a, the intermediate layer 155b, and the upper layer 155c of the gate electrode layer 155, and any combination thereof, the atomic ratio (N/M) of nitrogen (N) to metal (M) of the metal nitride may increase stepwise or continuously when moving away from the gate semiconductor layer 152 in the third direction D3.

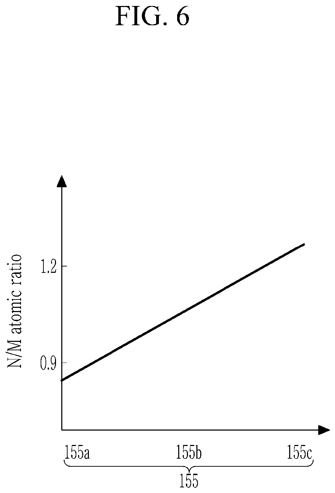

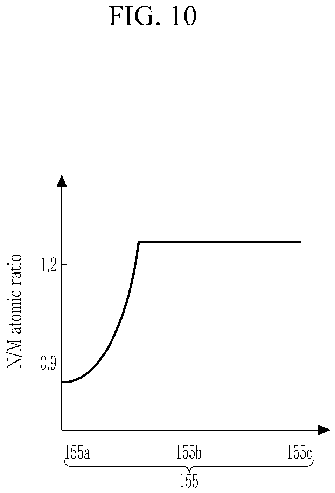

For example, in the gate electrode layer 155, the atomic ratio (N/M) of nitrogen (N) to metal (M) of the metal nitride may increase at a rate that is constant, decreases, or increases when moving away from the gate semiconductor layer 152 in the third direction D3. For example, when the increase rate of the atomic ratio (N/M) is constant, the atomic ratio (N/M) may increase in a linear function form along the third direction D3, when the increase rate of the atomic ratio (N/M) decreases, the atomic ratio (N/M) may increase in a logarithmic function form along the third direction D3, and when the increase rate of the atomic ratio (N/M) increases, the atomic ratio (N/M) may increase in an exponential function form along the third direction D3. For example, FIG. 5 shows that the increase rate of the atomic ratio (N/M) in the gate electrode layer 155 decreases. FIG. 6 shows that the increase rate of the atomic ratio (N/M) in the gate electrode layer 155 is constant. FIG. 10 shows that the increase rate of the atomic ratio (N/M) in the lower layer 155a of the gate electrode layer 155 increases.

For example, in the lower layer 155a of the gate electrode layer 155, the atomic ratio (N/M) of nitrogen (N) to metal (M) of the metal nitride may increase at a rate that is constant, decreases, or increases when moving away from the gate semiconductor layer 152 in the third direction D3. In the intermediate layer 155b of the gate electrode layer 155, the atomic ratio (N/M) of nitrogen (N) to metal (M) of the metal nitride may increase when moving away from the gate semiconductor layer 152 in the third direction D3, and the rate of increase may be constant, decrease, or increase. In the upper layer 155c of the gate electrode layer 155, the atomic ratio (N/M) of nitrogen (N) to metal (M) of the metal nitride may increase when moving away from the gate semiconductor layer 152 in the third direction D3, and the rate of increase may be constant, decrease, or increase.

For example, referring to FIG. 5, in the lower layer 155a of the gate electrode layer 155, the atomic ratio (N/M) may increase as the increase rate decreases, in the intermediate layer 155b, the atomic ratio (N/M) may increase as the increase rate decreases, and in the upper layer 155c, the atomic ratio (N/M) may increase as the increase rate decreases. The increase rate of the atomic ratio (N/M) in the lower layer 155a may be greater than the increase rate of the atomic ratio (N/M) in the intermediate layer 155b, and the increase rate of the atomic ratio (N/M) in the intermediate layer 155b may be greater than the increase rate of the atomic ratio (N/M) in the upper layer 155c. Additionally, in the gate electrode layer 155, the atomic ratio (N/M) of nitrogen (N) to metal (M) of the metal nitride may not only increase, but may also be continuous, when moving away from the gate semiconductor layer 152 in the third direction D3. In other words, at the interface between the lower layer 155a and the intermediate layer 155b of the gate electrode layer 155, the atomic ratio (N/M) in the lower layer 155a may be the same as the atomic ratio (N/M) in the intermediate layer 155b, and at the interface between the intermediate layer 155b and the upper layer 155c, the atomic ratio (N/M) in the intermediate layer 155b may be the same as the atomic ratio (N/M) in the upper layer 155c.

For example, referring to FIG. 6, the atomic ratio (N/M) in the lower layer 155a of the gate electrode layer 155 may increase while the increase rate is maintained constant, the atomic ratio (N/M) in the intermediate layer 155b may increase while the increase rate is maintained constant, and the atomic ratio (N/M) in the upper layer 155c may increase while the increase rate is maintained constant. The increase rate of the atomic ratio (N/M) in the lower layer 155a may be the same as the increase rate of the atomic ratio (N/M) in the intermediate layer 155b, and the increase rate of the atomic ratio (N/M) in the intermediate layer 155b may be the same as the increase rate of the atomic ratio (N/M) in the upper layer 155c. Additionally, in the gate electrode layer 155, the atomic ratio (N/M) of nitrogen (N) to metal (M) of the metal nitride may not only increase, but may also be continuous, when moving away from the gate semiconductor layer 152 in the third direction D3. In other words, at the interface between the lower layer 155a and the intermediate layer 155b of the gate electrode layer 155, the atomic ratio (N/M) in the lower layer 155a may be the same as the atomic ratio (N/M) in the intermediate layer 155b, and at the interface between the intermediate layer 155b and the upper layer 155c, the atomic ratio (N/M) in the intermediate layer 155b may be the same as the atomic ratio (N/M) in the upper layer 155c.

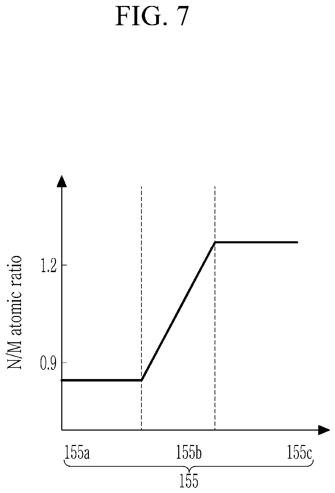

For example, referring to FIG. 7, in the lower layer 155a of the gate electrode layer 155, the atomic ratio (N/M) may be constant or increase while the increase rate is maintained constant, in the intermediate layer 155b, the atomic ratio (N/M) may increase while the increase rate is maintained constant, and in the upper layer 155c, the atomic ratio (N/M) may be constant or increase while the increase rate is maintained constant. In such implementations, the increase rate of the atomic ratio (N/M) in the intermediate layer 155b may be greater than the increase rate of the atomic ratio (N/M) in the lower layer 155a and the increase rate of the atomic ratio (N/M) in the upper layer 155c. Additionally, in the gate electrode layer 155, the atomic ratio (N/M) of nitrogen (N) to metal (M) of the metal nitride may not only increase, but may also be continuous, when moving away from the gate semiconductor layer 152 in the third direction D3. In other words, at the interface between the lower layer 155a and the intermediate layer 155b of the gate electrode layer 155, the atomic ratio (N/M) in the lower layer 155a may be the same as the atomic ratio (N/M) in the intermediate layer 155b, and at the interface between the intermediate layer 155b and the upper layer 155c, the atomic ratio (N/M) in the intermediate layer 155b may be the same as the atomic ratio (N/M) in the upper layer 155c.

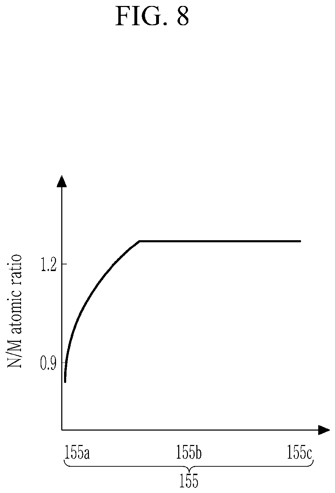

For example, referring to FIG. 8, in the lower layer 155a of the gate electrode layer 155, the atomic ratio (N/M) may increase with a decreasing increase rate, in the intermediate layer 155b, the atomic ratio (N/M) may be constant or increase with a constant increase rate, and in the upper layer 155c, the atomic ratio (N/M) may be constant or increase with a constant increase rate. In such implementations, the increase rate of the atomic ratio (N/M) in the lower layer 155a may be greater than the increase rate of the atomic ratio (N/M) in the intermediate layer 155b and the increase rate of the atomic ratio (N/M) in the upper layer 155c. Additionally, in the gate electrode layer 155, the atomic ratio (N/M) of nitrogen (N) to metal (M) of the metal nitride may not only increase, but may also be continuous when moving away from the gate semiconductor layer 152 in the third direction D3. In other words, at the interface between the lower layer 155a and the intermediate layer 155b of the gate electrode layer 155, the atomic ratio (N/M) in the lower layer 155a may be the same as the atomic ratio (N/M) in the intermediate layer 155b, and at the interface between the intermediate layer 155b and the upper layer 155c, the atomic ratio (N/M) in the intermediate layer 155b may be the same as the atomic ratio (N/M) in the upper layer 155c.

For example, referring to FIG. 9, the atomic ratio (N/M) in the lower layer 155a of the gate electrode layer 155 may increase while the increase rate is maintained constant, the atomic ratio (N/M) in the intermediate layer 155b may increase while the increase rate is maintained constant, and the atomic ratio (N/M) in the upper layer 155c may increase while the increase rate is maintained constant. In such implementations, the increase rate of the atomic ratio (N/M) in the lower layer 155a may be greater than the increase rate of the atomic ratio (N/M) in the intermediate layer 155b and the increase rate of the atomic ratio (N/M) in the upper layer 155c. Additionally, in the gate electrode layer 155, the atomic ratio (N/M) of nitrogen (N) to metal (M) of the metal nitride may increase stepwise when moving away from the gate semiconductor layer 152 in the third direction D3. In other words, at the interface between the lower layer 155a and the intermediate layer 155b of the gate electrode layer 155, the atomic ratio (N/M) in the lower layer 155a may be smaller than the atomic ratio (N/M) in the intermediate layer 155b. However, at the interface between the intermediate layer 155b and the upper layer 155c, the atomic ratio (N/M) in the intermediate layer 155b may be the same as the atomic ratio (N/M) in the upper layer 155c.

For example, referring to FIG. 10, in the lower layer 155a of the gate electrode layer 155, the atomic ratio (N/M) may increase as the increase rate increases, in the intermediate layer 155b, the atomic ratio (N/M) may be constant or increase while the increase rate is maintained constant, and in the upper layer 155c, the atomic ratio (N/M) may be constant or increase while the increase rate is maintained constant. In such implementations, the increase rate of the atomic ratio (N/M) in the lower layer 155a may be greater than the increase rate of the atomic ratio (N/M) in the intermediate layer 155b and the increase rate of the atomic ratio (N/M) in the upper layer 155c. Additionally, in the gate electrode layer 155, the atomic ratio (N/M) of nitrogen (N) to metal (M) of the metal nitride may not only increase, but may also be continuous, when moving away from the gate semiconductor layer 152 in the third direction D3. In other words, at the interface between the lower layer 155a and the intermediate layer 155b of the gate electrode layer 155, the atomic ratio (N/M) in the lower layer 155a may be the same as the atomic ratio (N/M) in the intermediate layer 155b, and at the interface between the intermediate layer 155b and the upper layer 155c, the atomic ratio (N/M) in the intermediate layer 155b may be the same as the atomic ratio (N/M) in the upper layer 155c.

As described above, in the gate electrode layer 155, the atomic ratio (N/M) of nitrogen (N) to metal (M) of the metal nitride is larger in the intermediate layer 155b than in the lower layer 155a, and larger in the upper layer 155c than in the intermediate layer 155b, and thus the resistivity of the gate electrode layer 155 may be smaller in the intermediate layer 155b than in the lower layer 155a, and smaller in the upper layer 155c than in the intermediate layer 155b.

For example, in the lower layer 155a of the gate electrode layer 155, the resistivity may be greater than or equal to about 160 µΩ·cm, for example greater than or equal to about 165 µΩ·cm, greater than or equal to about 170 µΩ·cm, greater than or equal to about 175 µΩ·cm, greater than or equal to about 180 µΩ·cm, greater than or equal to about 185 µΩ·cm, or greater than or equal to about 186 µΩ·cm, and less than or equal to about 190 µΩ·cm, for example less than or equal to about 189 µΩ·cm, less than or equal to about 186 µΩ·cm, less than or equal to about 180 µΩ·cm, less than or equal to about 175 µΩ·cm, or less than or equal to about 170 µΩ·cm.

In the upper layer 155c of the gate electrode layer 155, the resistivity may be greater than or equal to about 107 µΩ·cm, for example greater than or equal to about 110 µΩ·cm, greater than or equal to about 115 µΩ·cm, greater than or equal to about 120 µΩ·cm, greater than or equal to about 125 µΩ·cm, greater than or equal to about 130 µΩ·cm, or greater than or equal to about 135 µΩ·cm, and less than or equal to about 140 µΩ·cm, for example less than or equal to about 135 µΩ·cm, less than or equal to about 130 µΩ·cm, less than or equal to about 125 µΩ·cm, less than or equal to about 120 µΩ·cm, less than or equal to about 115 µΩ·cm, or less than or equal to about 110 µΩ·cm.

In the intermediate layer 155b of the gate electrode layer 155, the resistivity may have a value between the resistivity of the lower layer 155a and the resistivity of the upper layer 155c. In the intermediate layer 155b of the gate electrode layer 155, the resistivity may be greater than about 140 µΩ·cm, for example greater than or equal to about 145 µΩ·cm, greater than or equal to about 150 µΩ·cm, greater than or equal to about 155 µΩ·cm, greater than or equal to about 160 µΩ·cm, or greater than or equal to about 165 µΩ·cm, and less than about 170 µΩ·cm, for example less than or equal to about 165 µΩ·cm, less than or equal to about 160 µΩ·cm, less than or equal to about 155 µΩ·cm, less than or equal to about 150 µΩ·cm, or less than or equal to about 145 µΩ·cm.

In addition, in the gate electrode layer 155, the atomic ratio (N/M) of nitrogen (N) to metal (M) of the metal nitride is larger in the intermediate layer 155b than in the lower layer 155a, and larger in the upper layer 155c than in the intermediate layer 155b, and thus the work function of the gate electrode layer 155 may be smaller in the intermediate layer 155b than in the lower layer 155a, and smaller in the upper layer 155c than in the intermediate layer 155b.

In some implementations, in the lower layer 155a of the gate electrode layer 155, the work function may be greater than or equal to about 4.3 eV, for example greater than or equal to about 4.4 eV, greater than or equal to about 4.5 eV, or greater than or equal to about 4.6 eV, and less than or equal to about 4.7 eV, for example less than or equal to about 4.6 eV, less than or equal to about 4.5 eV, or less than or equal to about 4.4 eV, or may be about 4.3 eV to about 4.7eV.

In the upper layer 155c of the gate electrode layer 155, the work function may be greater than or equal to about 4.0 eV, for example greater than or equal to about 4.1 eV, or greater than or equal to about 4.2 eV, and less than about 4.3 eV, for example less than or equal to about 4.2 eV, or less than or equal to about 4.1 eV.

In the intermediate layer 155b of the gate electrode layer 155, the work function may have a value between the work function of the lower layer 155a and the work function of the upper layer 155c. In the intermediate layer 155b of the gate electrode layer 155, the work function may be greater than or equal to about 4.3 eV, for example greater than or equal to about 4.4 eV, or greater than or equal to about 4.5 eV, and less than or equal to about 4.6 eV, for example less than or equal to about 4.5 eV, or less than or equal to about 4.4 eV.

For example, the work function of the gate electrode layer 155 may be measured by ultraviolet photo-emission spectroscopy (UPS). For example, by gradually removing a surface of the gate electrode layer 155 in an inward direction, measuring the work function of the gate electrode layer 155 on the surface exposed thereby, and repeating this process, the work function along the thickness direction (i.e., the third direction D3) of the gate electrode layer 155 can be measured.

The measurement interval of the work function along the thickness direction (i.e., the third direction D3) may be equal to the thickness of the gate electrode layer 155 to be removed, and the measurement interval may be, for example, about 100 nm, about 90 nm, about 80 nm, about 70 nm, about 60 nm, about 50 nm, about 40 nm, about 30 nm, about 20 nm, about 10 nm, about 9 nm, about 8 nm, about 7 nm, about 6 nm, about 5 nm, about 4 nm, about 3 nm, about 2 nm, or about 1 nm.

Additionally, the size measured by ultraviolet photoelectron spectroscopy (UPS) on the surface of the exposed gate electrode layer 155 may be sufficiently large compared to the chemical structure of the metal nitride, and for example, the diameter of the measurement area may be about 10 mm, about 3 mm, about 1 mm, about 100 µm, about 10 µm, about 1 µm, about 100 nm, about 10 nm, or about 1 nm.

For example, a method of gradually removing one surface of the gate electrode layer 155 in an inward direction may utilize sputtering using Ar⁺ ions. The thickness of the gate electrode layer 155 to be removed may be controlled by controlling the time of sputtering using Ar⁺ ions.

For example, when the work function is measured at measurement intervals of x₁, x₂, x₃,..., xₙ along the third direction D3 of the gate electrode layer 155, and the values are f(x₁), f(x₂), f(x₃),..., f(xₙ), when the correlation coefficient values between f(x₁), f(x₂), f(x₃),..., f(xₙ) and x₁, x₂, x₃,..., xₙ are obtained, when all of the correlation coefficients obtained for the case where n is 4 or more have negative values, it can be defined that the work function substantially decreases.

For example, in the gate electrode layer 155, the work function may decrease when moving away from the gate semiconductor layer 152 in the third direction D3. In the gate electrode layer 155, the work function may not only decrease, but may also be continuous when moving away from the gate semiconductor layer 152 in the third direction D3. In other words, at the interface between the lower layer 155a and the intermediate layer 155b of the gate electrode layer 155, the work function in the lower layer 155a may be the same as the work function in the intermediate layer 155b. Additionally, at the interface between the intermediate layer 155b and the upper layer 155c, the work function in the intermediate layer 155b may be the same as the work function in the upper layer 155c. Alternatively, in the gate electrode layer 155, the work function may decrease stepwise when moving away from the gate semiconductor layer 152 in the third direction D3. In other words, at the interface between the lower layer 155a and the intermediate layer 155b of the gate electrode layer 155, the work function in the lower layer 155a may be greater than the work function in the intermediate layer 155b. Additionally, at the interface between the intermediate layer 155b and the upper layer 155c, the work function in the intermediate layer 155b may be greater than the work function in the upper layer 155c.

For example, in the lower layer 155a of the gate electrode layer 155, the work function may be constant, decrease stepwise, or decrease continuously when moving away from the gate semiconductor layer 152 in the third direction D3. In the intermediate layer 155b of the gate electrode layer 155, the work function may be constant, decrease stepwise, or decrease continuously when moving away from the gate semiconductor layer 152 in the third direction D3. In the upper layer 155c of the gate electrode layer 155, the work function may be constant, decrease stepwise, or decrease continuously when moving away from the gate semiconductor layer 152 in the third direction D3. However, in any one layer selected from the lower layer 155a, the intermediate layer 155b, and the upper layer 155c of the gate electrode layer 155, and any combination thereof, the work function may decrease stepwise or continuously when moving away from the gate semiconductor layer 152 in the third direction D3.

For example, in the gate electrode layer 155, the rate at which the work function decreases when moving away from the gate semiconductor layer 152 in the third direction D3 may be constant, decrease, or increase. For example, if the decrease rate of the work function is constant, the work function may decrease in a linear function form along the third direction D3, if the decrease rate of the work function decreases, the work function may decrease in a logarithmic function form along the third direction D3, and if the decrease rate of the work function increases, the work function may decrease in an exponential function form along the third direction D3.

For example, in the lower layer 155a of the gate electrode layer 155, a rate at which the work function decreases when moving away from the gate semiconductor layer 152 in the third direction D3 may be constant, decrease, or increase. In the intermediate layer 155b of the gate electrode layer 155, a rate of decrease in the work function when moving away from the gate semiconductor layer 152 in the third direction D3 may be constant, decrease, or increase. In the upper layer 155c of the gate electrode layer 155, a rate of decrease in the work function when moving away from the gate semiconductor layer 152 in the third direction D3 may be constant, decrease, or increase.

The semiconductor device may further include first to third protective layers 140, 150, and 160 on the barrier layer 136 and the gate electrode layer 155. For example, the semiconductor device may include a first protective layer 140, a second protective layer 150 on the first protective layer 140, and a third protective layer 160 on the second protective layer 150. The first protective layer 140 may cover the upper surface of the barrier layer 136 and the gate electrode layer 155 and may cover the side surface of the gate electrode layer 155 and the side surface of the gate semiconductor layer 152. The lower surface of the first protective layer 140 may be in contact with the barrier layer 136, the gate electrode layer 155, and the gate semiconductor layer 152. The upper surface of the first protective layer 140 may be in contact with the second protective layer 150. The second and third protective layers 150 and 160 may be separated from the barrier layer 136, the gate electrode layer 155, and the gate semiconductor layer 152 by the first protective layer 140. Therefore, the second and third protective layers 150 and 160 may not be in contact with the barrier layer 136, the gate electrode layer 155, and the gate semiconductor layer 152.

The barrier layer 136 or the gate electrode layer 155, etc., may be protected by the first to third protective layers 140, 150, and 160 and may be separated from other components. The first to third protective layers 140, 150, and 160 may include an insulating material. For example, the first to third protective layers 140, 150, and 160 may include oxides such as SiO₂ or Al₂O₃. As another example, the first to third protective layers 140, 150, and 160 may include a nitride such as SiN or an oxynitride such as SiON. The first to third protective layers 140, 150, and 160 may include the same material or may include different materials. When the first to third protective layers 140, 150, and 160 are made of the same material, the boundaries between the first to third protective layers 140, 150, and 160 may not be visible. The first to third protective layers 140, 150, and 160 may each be formed of a single layer or multiple layers.

The source electrode 173 and the drain electrode 175 may be located on the channel layer 132. The source electrode 173 and the drain electrode 175 may be spaced apart from each other in the second direction D2, and the gate electrode layer 155 and the gate semiconductor layer 152 may be located between the source electrode 173 and the drain electrode 175. The gate electrode layer 155 and the gate semiconductor layer 152 are spaced apart from the source electrode 173 and the drain electrode 175 in the second direction D2. The source electrode 173 may be electrically connected to the channel layer 132 on one side of the gate electrode layer 155. The drain electrode 175 may be electrically connected to the channel layer 132 on the other side of the gate electrode layer 155. The source electrode 173 and the drain electrode 175 may be located outside the drift region DTR of the channel layer 132. The interface between the source electrode 173 and the channel layer 132 may be one edge of the drift region DTR. Similarly, the interface between the drain electrode 175 and the channel layer 132 may be the other edge of the drift region DTR. However, the present disclosure is not limited thereto, and the source electrode 173 and the drain electrode 175 may not be located outside the drift region DTR of the channel layer 132. The channel layer 132 may not be recessed, and the source electrode 173 and the drain electrode 175 may be located on the upper surface of the channel layer 132. The lower surfaces of the source electrode 173 and the drain electrode 175 may be in contact with the upper surface of the channel layer 132. Additionally, the barrier layer 136 may not be recessed. The source electrode 173 and the drain electrode 175 may be located on the upper surface of the barrier layer 136. In other words, the lower surfaces of the source electrode 173 and the drain electrode 175 may be in contact with the upper surface of the barrier layer 136. The portion of the channel layer 132 or barrier layer 136 in contact with the source electrode 173 and the drain electrode 175 may be highly doped. Carriers passing through the two-dimensional electron gas 134 can be transferred to the source electrode 173 and the drain electrode 175 through a portion of the channel layer 132 or barrier layer 136 that is highly doped, i.e., the upper portion of the two-dimensional electron gas 134. The source electrode 173 and the drain electrode 175 may not be in direct horizontal contact with the two-dimensional electron gas 134. The horizontal direction may refer to a direction parallel to the upper surface of the channel layer 132 or the barrier layer 136.

The source electrode 173 and the drain electrode 175 may extend along the first direction D1 on a plane. That is, the source electrode 173 and the drain electrode 175 may have a rod shape extending along the first direction D1 on a plane. The source electrode 173 and the drain electrode 175 may extend in parallel directions. The source electrode 173 and the drain electrode 175 may extend in a direction parallel to the gate electrode layer 155.

The source electrode 173 and the drain electrode 175 may include a conductive material. For example, the source electrode 173 and the drain electrode 175 may include a metal, a metal alloy, conductive metal nitride, metal silicide, a doped semiconductor material, conductive metal oxide, or conductive metal oxynitride. For example, the source electrode 173 and the drain electrode 175 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof, but are not limited thereto. The source electrode 173 and the drain electrode 175 may be made of a single layer or multiple layers. The source electrode 173 and the drain electrode 175 may be in ohmic contact with the channel layer 132. A region in contact with the source electrode 173 and the drain electrode 175 within the channel layer 132 may be doped at a relatively high concentration compared to other regions.

The source electrode 173 may include a lower source electrode 173a, an intermediate source electrode 173b, and an upper source electrode 173c. The intermediate source electrode 173b may be located on the lower source electrode 173a. The upper source electrode 173c may be located on the intermediate source electrode 173b. The lower source electrode 173a may be in direct contact with the channel layer 132 and may be electrically connected to the channel layer 132. The intermediate source electrode 173b and the upper source electrode 173c may not be in direct contact with the channel layer 132 and may be electrically connected to the channel layer 132 through the lower source electrode 173a.

The drain electrode 175 may include a lower drain electrode 175a, an intermediate drain electrode 175b, and an upper drain electrode 175c. The intermediate drain electrode 175b may be located on the lower drain electrode 175a. The upper drain electrode 175c may be located on the intermediate drain electrode 175b. The lower drain electrode 175a may be in direct contact with the channel layer 132 and may be electrically connected to the channel layer 132. The intermediate drain electrode 175b and the upper drain electrode 175c may not be in direct contact with the channel layer 132 and may be electrically connected to the channel layer 132 through the lower drain electrode 175a.

The lower source electrode 173a and the lower drain electrode 175a may be located on the first protective layer 140. The lower source electrode 173a and the lower drain electrode 175a may be located between the first protective layer 140 and the second protective layer 150. The lower source electrode 173a and the lower drain electrode 175a penetrate the first protective layer 140 and the barrier layer 136, and the trenches recessing the upper surface of the channel layer 132 may be located on both sides of the gate electrode layer 155 to be spaced apart from each other. The lower source electrode 173a and the lower drain electrode 175a may be located in the trench on both sides of the gate electrode layer 155, respectively. The lower source electrode 173a and the lower drain electrode 175a may be formed to fill the trench. Within the trench, the lower source electrode 173a and the lower drain electrode 175a may contact the channel layer 132 and the barrier layer 136. The channel layer 132 may form the bottom and side walls of the trench, and the barrier layer 136 may form the side walls of the trench. Accordingly, the lower source electrode 173a and the lower drain electrode 175a may contact the upper surface and side surfaces of the channel layer 132. Additionally, the lower source electrode 173a and the lower drain electrode 175a may contact the side surface of the barrier layer 136. That is, the lower source electrode 173a and the lower drain electrode 175a may cover the side surfaces of the channel layer 132 and the barrier layer 136. The upper surfaces of the lower source electrode 173a and the lower drain electrode 175a may protrude from the upper surface of the first protective layer 140. Additionally, at least one of the lower source electrode 173a and the lower drain electrode 175a may cover at least a portion of the upper surface of the first protective layer 140. The second protective layer 150 may be located on the lower source electrode 173a and the lower drain electrode 175a. At least a portion of the lower source electrode 173a and the lower drain electrode 175a may be covered by the second protective layer 150.

The semiconductor device may further include a first field dispersion layer 177a on the first protective layer 140. The first field dispersion layer 177a may be located between the source electrode 173 and the drain electrode 175. The gate electrode layer 155 may be covered by a first field dispersion layer 177a. The first field dispersion layer 177a may be electrically connected to the source electrode 173. For example, the first field dispersion layer 177a may be connected to the lower source electrode 173a. The first field dispersion layer 177a may include the same material as the lower source electrode 173a and may be located in the same layer as the lower source electrode 173a. The first field dispersion layer 177a may be formed simultaneously with the lower source electrode 173a in the same process. The interface between the first field dispersion layer 177a and the lower source electrode 173a may not be clear, and the first field dispersion layer 177a may be formed integrally with the lower source electrode 173a. However, the present disclosure is not limited thereto, and the first field dispersion layer 177a may be a separate element from the lower source electrode 173a. Additionally, the first field dispersion layer 177a may be located in a different layer from the lower source electrode 173a and may be formed in a different process. In some cases, the first field dispersion layer 177a may be electrically connected to the gate electrode layer 155. For example, an opening that is overlapped with the gate electrode 155 may be formed in the first protective layer 140, and the first field dispersion layer 177a may be connected to the gate electrode layer 155 through the opening. In such implementations, the first field dispersion layer 177a may not be connected to the source electrode 173.

The semiconductor device may further include a second field dispersion layer 177b located on the second protective layer 150. The second field dispersion layer 177b may form a field dispersion layer together with the first field dispersion layer 177a. The second field dispersion layer 177b may be located between the source electrode 173 and the drain electrode 175. The second field dispersion layer 177b may be overlapped with the gate electrode layer 155 in the third direction D3. The second field dispersion layer 177b may be overlapped with the first field dispersion layer 177a in the third direction D3. The gate electrode 155 and the first field dispersion layer 177a may be covered by the second field dispersion layer 177b. The second field dispersion layer 177b may be wider than the first field dispersion layer 177a. The second field dispersion layer 177b may entirely cover the first field dispersion layer 177a. However, the present disclosure is not limited thereto, and the width and positional relationship of the first field dispersion layer 177a and the second field dispersion layer 177b may be changed in various ways. The second field dispersion layer 177b may be electrically connected to the source electrode 173. For example, the second field dispersion layer 177b may be connected to the intermediate source electrode 173b. The second field dispersion layer 177b may include the same material as the intermediate source electrode 173b and may be located in the same layer as the intermediate source electrode 173b. The second field dispersion layer 177b may be formed simultaneously with the intermediate source electrode 173b in the same process. The interface between the second field dispersion layer 177b and the intermediate source electrode 173b may not be clear, and the second field dispersion layer 177b may be formed integrally with the intermediate source electrode 173b. However, the present disclosure is not limited thereto, and the second field dispersion layer 177b may be a separate element separated from the intermediate source electrode 173b. Additionally, the second field dispersion layer 177b may be located in a different layer from the intermediate source electrode 173b and may be formed in a different process.

The semiconductor device may further include a third field dispersion layer 177c on the third protective layer 160. The third field dispersion layer 177c may form a field dispersion layer together with the first field dispersion layer 177a and the second field dispersion layer 177b. The third field dispersion layer 177c may be located between the source electrode 173 and the drain electrode 175. The third field dispersion layer 177c may be overlapped with the gate electrode layer 155 in the third direction D3. The third field dispersion layer 177c may be overlapped with the first field dispersion layer 177a and the second field dispersion layer 177b in the third direction D3. The gate electrode layer 155, the first field dispersion layer 177a, and the second field dispersion layer 177b may be covered by the third field dispersion layer 177c. The third field dispersion layer 177c may be wider than a width of the second field dispersion layer 177b. The third field dispersion layer 177c may entirely cover the second field dispersion layer 177b. However, the present disclosure is not limited thereto, and the width and positional relationship of the first field dispersion layer 177a, the second field dispersion layer 177b, and the third field dispersion layer 177c may be changed in various ways. The third field dispersion layer 177c may be electrically connected to the source electrode 173. For example, the third field dispersion layer 177c may be connected to the upper source electrode 173c. The third field dispersion layer 177c may include the same material as the upper source electrode 173c and may be located in the same layer as the upper source electrode 173c. The third field dispersion layer 177c may be formed simultaneously in the same process as the upper source electrode 173c. The interface between the third field dispersion layer 177c and the upper source electrode 173c may not be clear, and the third field dispersion layer 177c may be formed integrally with the upper source electrode 173c. However, the present disclosure is not limited thereto, and the third field dispersion layer 177c may be a separate element separated from the upper source electrode 173c. Additionally, the third field dispersion layer 177c may be located in a different layer from the upper source electrode 173c and may be formed in a different process.

In some implementations, at least one of the first field dispersion layer 177a, the second field dispersion layer 177b, or the third field dispersion layer 177c may be omitted. For example, the semiconductor device may include the first field dispersion layer 177a and may not include the second field dispersion layer 177b or the third field dispersion layer 177c. Alternatively, the semiconductor device may include the second field dispersion layer 177b and not include the first field dispersion layer 177a or the third field dispersion layer 177c. Alternatively, the semiconductor device may include the third field dispersion layer 177c and not include the first field dispersion layer 177a or the second field dispersion layer 177b. Alternatively, the semiconductor device may not include the first field dispersion layer 177a, the second field dispersion layer 177b, and the third field dispersion layer 177c.

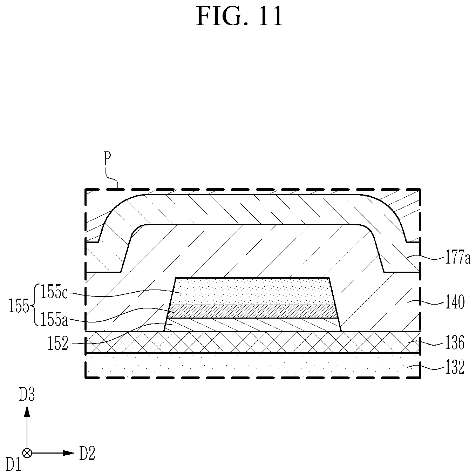

FIG. 11 is an enlarged cross-sectional view of portion P of FIG. 2, showing some implementations.

Since the implementations shown in FIG. 11 have many of the same parts as the implementations shown in FIG. 3, descriptions thereof will be omitted and the differences will be mainly explained. Additionally, the same reference numerals are used for the same components as those in the previous implementations.

Referring to FIG. 11, the gate electrode layer 155 may have a lower layer 155a on the gate semiconductor layer 152 in the third direction D3, and an upper layer 155c on the lower layer 155a. In other words, the gate electrode layer 155 may not have an intermediate layer 155b.

In other words, the lower layer 155a of the gate electrode layer 155 may be located closest to the gate semiconductor layer 152 in the third direction D3, the upper layer 155c may be located farthest from the gate semiconductor layer 152 in the third direction D3, the upper layer 155c may be located on the lower layer 155a, and the lower surface of the upper layer 155c and the upper surface of the lower layer 155a may be in contact with each other. In other words, the lower layer 155a and the upper layer 155c may be sequentially stacked in the third direction D3.

In this case, a dimension of the upper layer 155c in the third direction D3 may be greater than a dimension of the lower layer 155a in the third direction D3. For example, the dimension of the upper layer 155c in the third direction D3 may be at least twice the dimension of the lower layer 155a in the third direction D3. Additionally, the dimension of the upper layer 155c in the third direction D3 may be less than or equal to about 90 %, for example less than or equal to about 80 %, less than or equal to about 70 %, less than or equal to about 60 %, less than or equal to about 50 %, less than or equal to about 40 %, less than or equal to about 30 %, or less than or equal to about 20 %, and greater than or equal to about 10 %, greater than or equal to about 20 %, greater than or equal to about 30 %, greater than or equal to about 40 %, greater than or equal to about 50 %, greater than or equal to about 60 %, greater than or equal to about 70 %, or greater than or equal to about 80 % based on a total thickness of the gate electrode layer 155. The dimension of the lower layer 155a in the third direction D3 may be less than or equal to about 50 %, for example less than or equal to about 40 %, less than or equal to about 30 %, less than or equal to about 20 %, less than or equal to about 10 %, or less than or equal to about 5 %, and greater than or equal to about 1 %, greater than or equal to about 5 %, greater than or equal to about 10 %, greater than or equal to about 20 %, greater than or equal to about 30 %, or greater than or equal to about 40 %, or may be about 1 % to about 30 %, or about 1 % to about 10 % based on a total thickness of the gate electrode layer 155.

For example, in the gate electrode layer 155, the atomic ratio (N/M) of nitrogen (N) to metal (M) of the metal nitride may be greater in the upper layer 155c than in the lower layer 155a. In the lower layer 155a of the gate electrode layer 155, the atomic ratio (N/M) of nitrogen (N) to metal (M) may be greater than or equal to about 0.6, for example greater than or equal to about 0.7, greater than or equal to about 0.8, or greater than or equal to about 0.9, and less than about 1.0, for example less than or equal to about 0.9, less than or equal to about 0.8, or less than or equal to about 0.7, or may be about 0.6 to less than about 1.0, or about 0.8 to about 0.9. In the upper layer 155c of the gate electrode layer 155, the atomic ratio (N/M) of nitrogen (N) to metal (M) may be greater than about 0.9, for example greater than or equal to about 1.0, greater than or equal to about 1.1, greater than or equal to about 1.2, greater than or equal to about 1.3, or greater than or equal to about 1.4, and less than or equal to about 1.5, for example, less than or equal to about 1.4, less than or equal to about 1.3, less than or equal to about 1.2, or less than or equal to about 1.1, or may be about 1.0 to about 1.5, or about 1.0 to about 1.2.

For example, referring to FIGS. 8 to 10, in the lower layer 155a of the gate electrode layer 155, the atomic ratio (N/M) may increase as the increase rate decreases, increase as the increase rate remains constant, or increase as the increase rate increases, and in the upper layer 155c, the atomic ratio (N/M) may remain constant or increase as the increase rate remains constant. In such implementations, the increase rate of the atomic ratio (N/M) in the lower layer 155a may be greater than the increase rate of the atomic ratio (N/M) in the upper layer 155c.

Additionally, as shown in FIGS. 8 and 10, in the gate electrode layer 155, the atomic ratio (N/M) of nitrogen (N) to metal (M) of the metal nitride may not only increase, but may also be continuous, when moving away from the gate semiconductor layer 152 in the third direction D3. In other words, at the interface between the lower layer 155a and the upper layer 155c of the gate electrode layer 155, the atomic ratio (N/M) in the lower layer 155a may be the same as the atomic ratio (N/M) in the upper layer 155c.

Alternatively, as in FIG. 9, in the gate electrode layer 155, the atomic ratio (N/M) of nitrogen (N) to metal (M) of the metal nitride may increase stepwise as it moves away from the gate semiconductor layer 152 in the third direction D3. In other words, at the interface between the lower layer 155a and the upper layer 155c of the gate electrode layer 155, the atomic ratio (N/M) in the lower layer 155a may be smaller than the atomic ratio (N/M) in the upper layer 155c.

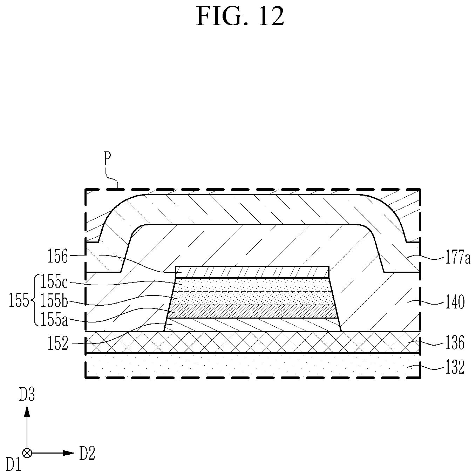

FIG. 12 is an enlarged cross-sectional view of portion P of FIG. 2, showing some implementations.

Since the implementations shown in FIG. 12 have many of the same parts as the implementations shown in FIG. 3, descriptions thereof will be omitted and the differences will be mainly explained. Additionally, the same reference numerals are used for the same components as those in the previous implementations.

Referring to FIG. 12, a hard mask layer 156 on the gate electrode layer 155 may be further included. The hard mask layer 156 may be a hard mask used when patterning a gate electrode material layer 155L or a gate semiconductor material layer 152L in the process of forming a gate electrode layer 155 described later. However, the hard mask layer 156 may be removed depending on the etching conditions during the etching of the gate semiconductor material layer 152L or depending on the cleaning conditions after the etching. For example, the hard mask layer 156 may include silicon oxide, silicon nitride, silicon oxynitride, or a combination thereof.

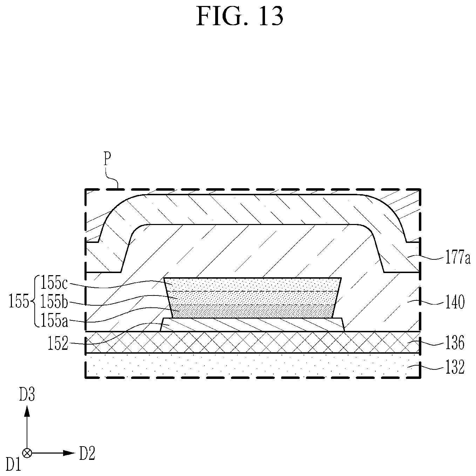

FIG. 13 is an enlarged cross-sectional view of portion P of FIG. 2, showing some implementations.

Since the implementations shown in FIG. 13 have many of the same parts as the implementations shown in FIG. 3, descriptions thereof will be omitted and the differences will be mainly explained. Additionally, the same reference numerals are used for the same components as those in the previous implementations.

In FIG. 3, the side surfaces of the gate semiconductor layer 152 and the gate electrode layer 155 are depicted as being inclined in a cross-section cut in the second direction D2 and the third direction D3 perpendicular to the first direction D1. For example, the dimension of the gate semiconductor layer 152 and the gate electrode layer 155 in the second direction D2 may decrease from the lower surface of the gate semiconductor layer 152 to the upper surface of the gate electrode layer 155 along the third direction D3. In other words, the dimension of the upper surface of the gate semiconductor layer 152 in the second direction D2 may be smaller than the dimension of the lower surface of the gate semiconductor layer 152 in the second direction D2. The dimension of the upper surface of the gate electrode layer 155 in the second direction D2 may be smaller than the dimension of the lower surface of the gate electrode layer 155 in the second direction D2. The dimension of the upper surface of the upper layer 155c of the gate electrode layer 155 in the second direction D2 may be smaller than the dimension of the lower surface of the upper layer 155c of the gate electrode layer 155 in the second direction D2. The dimension of the upper surface of the intermediate layer 155b of the gate electrode layer 155 in the second direction D2 may be smaller than the dimension of the lower surface of the intermediate layer 155b of the gate electrode layer 155 in the second direction D2. The dimension of the upper surface of the lower layer 155a of the gate electrode layer 155 in the second direction D2 may be smaller than the dimension of the lower surface of the lower layer 155a of the gate electrode layer 155 in the second direction D2.

In FIG. 13, the side surfaces of the gate semiconductor layer 152 and the gate electrode layer 155 are shown as being inclined in a cross-section cut in the second direction D2 and the third direction D3 perpendicular to the first direction D1, but a slope of the side surfaces may be such that the dimension of the gate electrode layer 155 in the second direction D2 increases from the lower surface of the gate electrode layer 155 to the upper surface of the gate electrode layer 155 along the third direction D3.

However, even in this case, the gate semiconductor layer 152 may have a slope such that the dimension in the second direction D2 becomes smaller when moving from the lower surface of the gate semiconductor layer 152 to the upper surface of the gate semiconductor layer 152 along the third direction D3. In other words, the dimension of the upper surface of the gate semiconductor layer 152 in the second direction D2 may be smaller than the dimension of the lower surface of the gate semiconductor layer 152 in the second direction D2.

On the other hand, the dimension of the upper surface of the gate electrode layer 155 in the second direction D2 may be greater than the dimension of the lower surface of the gate electrode layer 155 in the second direction D2. The dimension of the upper surface of the upper layer 155c of the gate electrode layer 155 in the second direction D2 may be greater than the dimension of the lower surface of the upper layer 155c of the gate electrode layer 155 in the second direction D2. The dimension of the upper surface of the intermediate layer 155b of the gate electrode layer 155 in the second direction D2 may be greater than the dimension of the lower surface of the intermediate layer 155b of the gate electrode layer 155 in the second direction D2. The dimension of the upper surface of the lower layer 155a of the gate electrode layer 155 in the second direction D2 may be greater than the dimension of the lower surface of the lower layer 155a of the gate electrode layer 155 in the second direction D2.

For example, the dimension of the upper surface of the gate semiconductor layer 152 in the second direction D2 may be substantially the same as the dimension of the upper surface of the upper layer 155c of the gate electrode layer 155 in the second direction D2.

In this case, as the dimension of the gate electrode layer 155 in the second direction D2 increases from the lower layer 155a to the intermediate layer 155b and the upper layer 155c of the gate electrode layer 155, a content of metal nitride having a higher atomic ratio (N/M) of nitrogen (N) to metal (M) increases, thereby further enhancing the low resistance characteristics of the gate electrode layer 155, and further improving the switching speed of the semiconductor device.

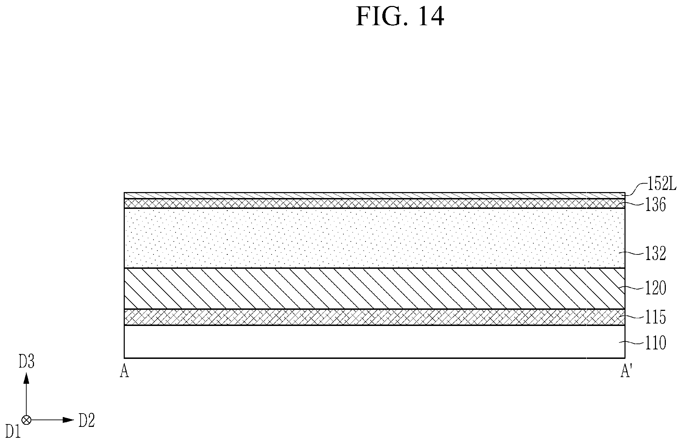

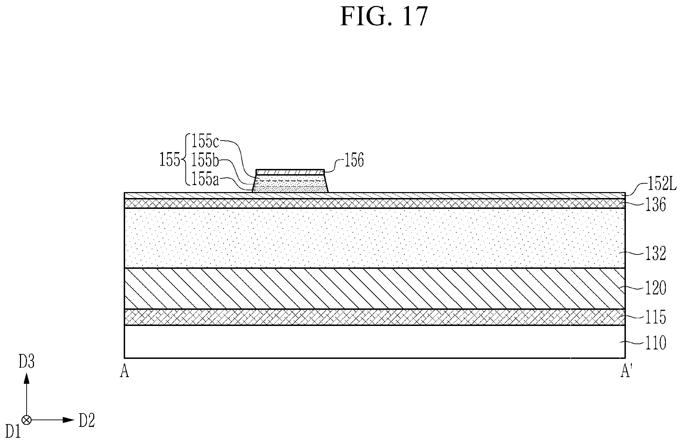

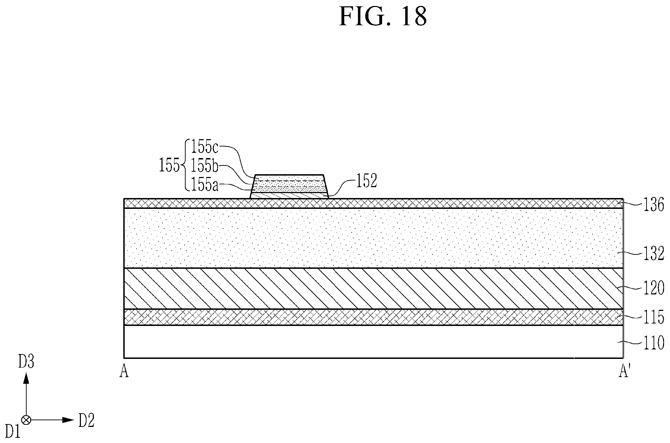

Next, a method for manufacturing a semiconductor device according to some implementations will be described with reference to FIGS. 14 to 20. In addition, FIGS. 1 to 3 described above may be referred.

FIGS. 14 to 20 are cross-sectional views showing a method for manufacturing a semiconductor device in the order of processes.

Referring to FIG. 14, a seed layer 115, a buffer layer 120, a channel layer 132, and a barrier layer 136 may be sequentially formed on a substrate 110. Additionally, a gate semiconductor material layer 152L may be formed on the barrier layer 136.

For example, the seed layer 115, the buffer layer 120, the channel layer 132, the barrier layer 136, and the gate semiconductor material layer 152L may be formed sequentially using an epitaxial growth method. The seed layer 115 may be first formed on the substrate 110, and the buffer layer 120 may be formed on the seed layer 115. The buffer layer 120 may include a superlattice layer and a high-resistance layer. The channel layer 132 may be formed on the buffer layer 120, the barrier layer 136 may be formed on the channel layer 132, and a gate semiconductor material layer 152L can be formed on the barrier layer 136.

For example, equipment for growing the seed layer 115, the buffer layer 120, the channel layer 132, the barrier layer 136, and the gate semiconductor material layer 152L may use metal organic chemical vapor deposition (MOCVD), hydride vapor phase epitaxy (HVPE), or molecular beam epitaxy (MBE).

The seed layer 115, the buffer layer 120, the channel layer 132, the barrier layer 136, and the gate semiconductor material layer 152L may be made of the same semiconductor material. However, the material composition ratio of each layer may be different depending on the role of each layer and the performance required for the semiconductor device.

For example, the substrate 110 includes Si, the seed layer 115 includes AlN, and the superlattice layer of the buffer layer 120 has a structure in which a layer made of AlGaN and a layer made of GaN are repeatedly stacked. The high-resistance layer of the buffer layer 120 may include GaN, the channel layer 132 may include GaN, and the barrier layer 136 may include AlGaN. The channel layer 132 and the barrier layer 136 may be doped with impurities or may not be doped. The gate semiconductor material layer 152L may include GaN and may be doped with impurities. The gate semiconductor material layer 152L may be doped with a p-type impurity, for example, magnesium (Mg).

As the lattice structure of Si and GaN are different, it may not be easy to grow the channel layer 132 made of GaN directly on the substrate 110 made of Si. Accordingly, by first forming the seed layer 115 or the buffer layer 120 on the substrate 110 and then forming the channel layer 132, the lattice structure of the channel layer 132 can be stably formed.

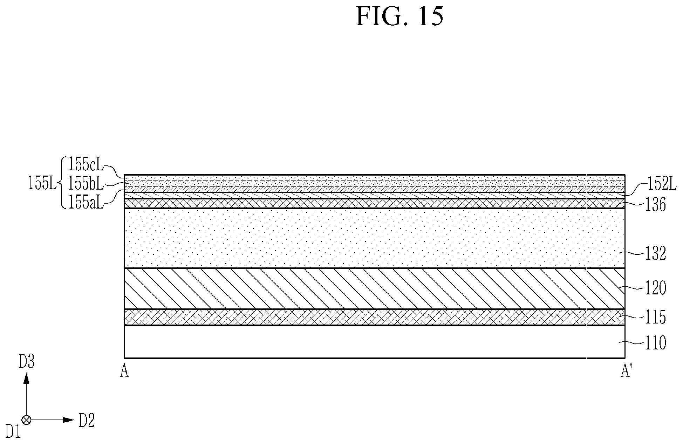

Referring to FIG. 15, a gate electrode material layer 155L may be formed on the gate semiconductor material layer 152L.

As an example, the gate electrode material layer 155L may be formed using a deposition process. For example, the gate electrode material layer 155L may be formed using electron beam evaporation (E-beam evaporation), sputtering, physical vapor deposition (PVD), thermal chemical vapor deposition (thermal CVD), low pressure chemical vapor deposition (LP-CVD), plasma-enhanced chemical vapor deposition (PE-CVD), or atomic layer deposition (ALD), etc., but is not limited thereto.

For example, when the gate electrode material layer 155L is formed of titanium nitride (TiN), the deposition of titanium nitride (TiN) can use argon (Ar) as a sputtering gas and nitrogen (N₂) as a reactive gas. The substrate temperature may be about 27 °C to about 600 °C, the target power may be about 50 W to about 1000 W, the sputter gas pressure may be about 0.1 Pa to about 1.0 Pa, the argon (Ar) flow rate may be about 0 sccm to about 100 sccm (about 0 Pa·m³/sec to about 1.69×10⁻¹ Pa·m³/sec), and the nitrogen (N₂) gas flow rate may be about 0 sccm to about 200 sccm (about 0 Pa·m³/sec to about 3.37×10⁻¹ Pa·m³/sec).

The atomic ratio (N/Ti) of nitrogen (N) to titanium (Ti) in titanium nitride (TiN) may be adjusted by the mixing ratio of argon and nitrogen introduced during sputtering. Through this, the gate electrode material layer 155L may be formed having a lower material layer 155aL, an intermediate material layer 155bL, and an upper material layer 155cL having different atomic ratios (N/Ti) of nitrogen (N) to titanium (Ti) in titanium nitride (TiN).

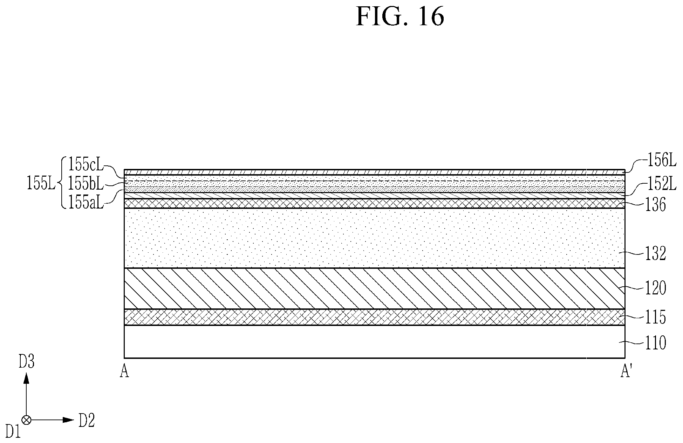

Referring to FIGS. 16 to 18, the gate semiconductor material layer 152L and the gate electrode material layer 155L are etched to form a gate semiconductor layer 152 and a gate electrode layer 155, respectively.

For example, a hard mask 156L may be formed on a gate electrode material layer 155L, a photoresist may be formed on the hard mask 156L, and the hard mask 156L and the gate electrode material layer 155L may be patterned using the photoresist as an etching mask, and a gate semiconductor material layer 152L may be patterned using the hard mask layer 156 as an etching mask, thereby forming the gate semiconductor layer 152 and the gate electrode layer 155, respectively.

For example, the hard mask 156L may be a spin-on hardmask layer (SOH). The spin-on hard mask layer may be formed on the gate electrode material layer 155L through a spin coating process. The hard mask 156L may include silicon oxide, silicon nitride, silicon oxynitride, or a combination thereof.

For example, etching of the gate semiconductor material layer 152L and the gate electrode material layer 155L may be performed by dry etching using an etching gas. The etching gas may include a fluoride gas or a chloride gas. For example, the fluoride gas may include, for example, SF₆, CHF₃, CF₄, or a mixed gas thereof, the chloride gas may include Cl₂, BCl₃, or a mixed gas thereof, the gate electrode material layer 155L may be etched using SF₆ gas, and the gate semiconductor material layer 152L may be etched using a mixed gas of Cl₂ and O₂ or a mixed gas of BCl₃ and SF₆.

In some implementations, after etching the gate semiconductor material layer 152L and the gate electrode material layer 155L, a treatment process may be performed to remove byproducts and reduce damage to the barrier layer 136 due to dry etching. For example, byproduct removal may be accomplished through an ashing or stripping process. The ashing process and stripping process may be performed sequentially. For example, an ashing process may be performed first to remove byproducts using the oxygen (O₂) plasma treatment process or the ozone (O₃) treatment process, and then the stripping process may be performed. Apart from the ashing process or strip process, dry and wet treatment processes may be performed. For example, the treatment process may include a dry cleaning process using, for example, N₂O plasma, N₂ plasma, NH₃ plasma, or O₂ plasma, or a wet cleaning process using diluted HF (DHF), BOE, or ammonium hydroxide (NH₄OH). In this process, the hard mask layer 156 remaining on the gate electrode layer 155 may be removed.

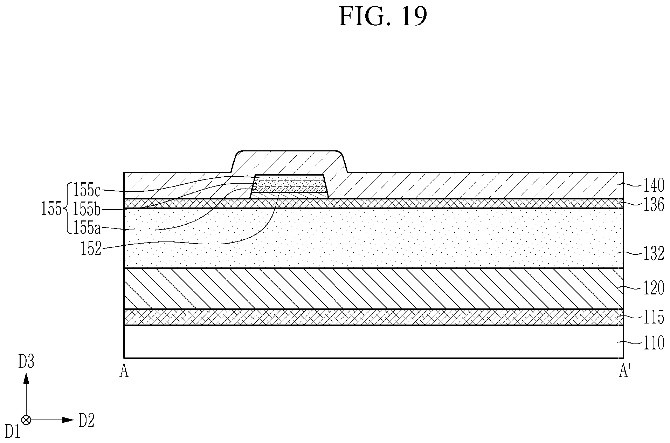

Referring to FIG. 19, a first protective layer 140 may be formed on the barrier layer 136, the gate semiconductor layer 152, and the gate electrode layer 155. The first protective layer 140 may be formed using a deposition process. The first protective layer 140 may include an insulating material. For example, the first protective layer 140 may include a material such as SiO₂, SiN, SiON, or Al₂O₃. The first protective layer 140 is shown as a single layer but may be composed of multiple layers in some cases. In such implementations, the first protective layer 140 may be formed by sequentially depositing different materials. Alternatively, the first protective layer 140 may be formed of several layers with different characteristics by using the same material and varying deposition conditions. In particular, the portion of the first protective layer 140 adjacent to the barrier layer 136 may be made of an insulating material of much higher quality than other portions. This is to prevent electrons forming a channel from being trapped in the channel layer 132 under the barrier layer 136. The portion of the first protective layer 140 that is in contact with the barrier layer 136 may be made of SiO₂.

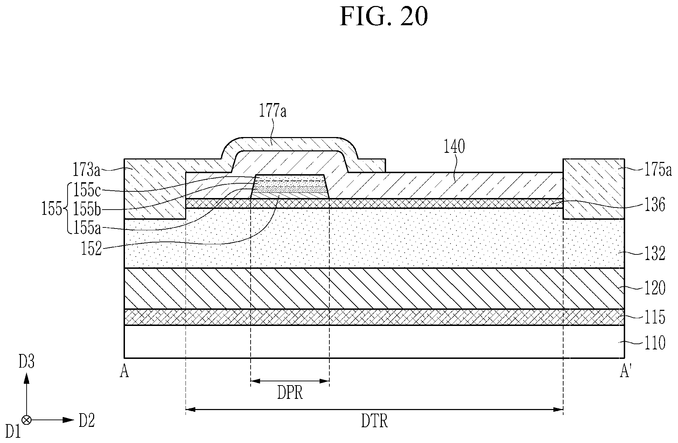

Referring to FIG. 20, a first protective layer 140 may be patterned to form a trench, and a lower source electrode 173a and a lower drain electrode 175a may be formed within the trench. In the process of forming a trench, not only the first protective layer 140 but also a portion of the barrier layer 136 and the channel layer 132 may be patterned together. Additionally, the first field dispersion layer 177a may be formed together in the process of forming the lower source electrode 173a and the lower drain electrode 175a.

The lower source electrode 173a and the lower drain electrode 175a may be in ohmic contact with the channel layer 132. The region in contact with the lower source electrode 173a and the lower drain electrode 175a within the channel layer 132 may be doped at a relatively high concentration compared to other regions. For example, the channel layer 132 may be doped by an ion implant process, an annealing process, etc. However, it is not limited to this, and the doping process of the channel layer 132 may be performed through various other processes. The doping process of the channel layer 132 may be performed before forming the lower source electrode 173a and the lower drain electrode 175a. In some cases, the channel layer 132 may not be doped.

Referring again to FIGS. 1 to 3, a second protective layer 150 may be formed on the first protective layer 140, the lower source electrode 173a, the lower drain electrode 175a, and the first field dispersion layer 177a, the second protective layer 150 may be patterned to form a trench, an intermediate source electrode 173b and an intermediate drain electrode 175b may be formed within the trench, and the second field dispersion layer 177b may be formed together.

In addition, a third protective layer 160 may be formed on the second protective layer 150, the intermediate source electrode 173b, the intermediate drain electrode 175b, and the second field dispersion layer 177b, the third protective layer 160 may be patterned to form a trench, an upper source electrode 173c and an upper drain electrode 175c may be formed within the trench, and the third field dispersion layer 177c may be formed together.

While this specification contains many specific implementation details, these should not be construed as limitations on the scope of any invention or on the scope of what may be claimed, but rather as descriptions of features that may be specific to particular implementations. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While this disclosure has been described in connection with what is presently considered to be practical implementations, it is to be understood that the disclosure is not limited to the disclosed implementations, but, on the contrary, is intended to cover various modifications and equivalent arrangements included within the scope of the appended claims.

## Claims

1. A semiconductor device comprising
a channel layer (132),
a barrier layer (136) located on the channel layer (132) and including a material having an energy bandgap different from that of the channel layer (132),
a gate electrode layer (155) located on the barrier layer (136) and extending in a first direction (D1),
a gate semiconductor layer (152) between the barrier layer (136) and the gate electrode layer (155), and
a source electrode (173) and a drain electrode (175) electrically connected to the channel layer (132) and being spaced apart from the gate electrode layer (155) in a second direction (D2) different from the first direction (D1),
wherein the gate electrode layer (155) includes a metal nitride,
wherein the gate electrode layer (155) has a lower layer (155a) on the gate semiconductor layer (152), an intermediate layer (155b) on the lower layer (155a), and an upper layer (155c) on the intermediate layer (155b) in a third direction (D3) different from the first direction (D1) and the second direction (D2), and
wherein, in the gate electrode layer (155), an atomic ratio of nitrogen to metal of the metal nitride is greater in the intermediate layer (155b) than in the lower layer (155a), and is greater in the upper layer (155c) than in the intermediate layer (155b).

2. The semiconductor device of claim 1, wherein
the metal nitride includes at least one of titanium nitride, titanium silicon nitride, tantalum nitride, tantalum silicon nitride, tantalum titanium nitride , titanium aluminum nitride, tantalum aluminum nitride, tungsten nitride, or titanium aluminum carbon nitride.

3. The semiconductor device of claim 1 or 2, wherein
in the lower layer (155a) of the gate electrode layer (155), the atomic ratio of nitrogen to the metal is from 0.6 to less than 1.0, and
in the upper layer (155c) of the gate electrode layer (155), the atomic ratio of nitrogen to the metal is from 1.0 to 1.5.

4. The semiconductor device of any preceding claim, wherein
in the intermediate layer (155b) of the gate electrode layer (155), the atomic ratio of nitrogen to the metal is greater than 0.9 and less than 1.2.

5. The semiconductor device of any preceding claim, wherein
a thickness of the gate electrode layer (155) is 500 Å to 2000 Å, and
each thickness of the lower layer (155a), the intermediate layer (155b), and the upper layer (155c) of the gate electrode layer (155) is 10 Å to 700 Å.

6. The semiconductor device of any preceding claim, wherein
the gate electrode layer (155) includes a portion in which the atomic ratio of the nitrogen to the metal of the metal nitride increases in the third direction (D3) away from the gate semiconductor layer (152).

7. The semiconductor device of any preceding claim, wherein
in the gate electrode layer (155), the atomic ratio of the nitrogen to the metal of the metal nitride increases stepwise or continuously in the third direction (D3) away from the gate semiconductor layer (152).

8. The semiconductor device of any preceding claim, wherein
at an interface between the lower layer (155a) and the intermediate layer (155b) of the gate electrode layer (155), the atomic ratio in the lower layer (155a) is the same as the atomic ratio in the intermediate layer (155b), and
at an interface between the intermediate layer (155b) and the upper layer (155c), the atomic ratio in the intermediate layer (155b) is the same as the atomic ratio in the upper layer (155c).

9. The semiconductor device of any one of claims 1 to 7, wherein
at an interface between the lower layer (155a) and the intermediate layer (155b) of the gate electrode layer (155), the atomic ratio in the lower layer (155a) is smaller than the atomic ratio in the intermediate layer (155b), and
at an interface between the intermediate layer (155b) and the upper layer (155c), the atomic ratio in the intermediate layer (155b) is smaller than the atomic ratio in the upper layer (155c).

10. The semiconductor device of any preceding claim, wherein
in the lower layer (155a) of the gate electrode layer (155), the atomic ratio of nitrogen to the metal of the metal nitride is constant, increases stepwise, or increases continuously in the third direction (D3) away from the gate semiconductor layer (152),
in the intermediate layer (155b) of the gate electrode layer (155), the atomic ratio of the nitrogen to the metal of the metal nitride is constant, increases stepwise, or increases continuously in the third direction (D3) away from the gate semiconductor layer (152),
in the upper layer (155c) of the gate electrode layer (155), the atomic ratio of the nitrogen to the metal of the metal nitride is constant, increases stepwise, or increases continuously in the third direction (D3) away from the gate semiconductor layer (155), and
in at least one of the lower layer (155a), the intermediate layer (155b), or the upper layer (155c), the atomic ratio of nitrogen to the metal of the metal nitride increases in the third direction (D3) away from the gate semiconductor layer (152).

11. The semiconductor device of any preceding claim, wherein
in the gate electrode layer (155), the atomic ratio of the nitrogen to the metal of the metal nitride increases at a rate that is constant, decreases, or increases in the third direction (D3) away from the gate semiconductor layer.

12. The semiconductor device of any preceding claim, wherein
in the lower layer (155a) of the gate electrode layer (155), the atomic ratio of the nitrogen to the metal of the metal nitride increases at a rate that is constant, decreases, or increases in the third direction (D3) away from the gate semiconductor layer (152),
in the intermediate layer (155b) of the gate electrode layer (155), the atomic ratio of the nitrogen to the metal of the metal nitride increases at a rate that is constant, decreases, or increases in the third direction (D3) away from the gate semiconductor layer (152), and
in the upper layer (155c) of the gate electrode layer (155), the atomic ratio of the nitrogen to the metal of the metal nitride increases at a rate that is constant, decreases, or increases in the third direction (D3) away from the gate semiconductor layer (152).

13. The semiconductor device of any preceding claim,
wherein a work function of the gate electrode layer (155) is smaller in the intermediate layer (155b) than in the lower layer (155a) and is smaller in the upper layer (155c) than in the intermediate layer (155b).

14. The semiconductor device of any preceding claim,
wherein a dimension of an upper surface of the gate electrode layer (155) in the second direction (D2) is shorter than a dimension of a lower surface of the gate electrode layer (155) in the second direction (D2).

15. The semiconductor device of any preceding claim, wherein
the semiconductor device further includes a hard mask layer (156) on the gate electrode layer (155).
